# EUROPEAN PATENT SPECIFICATION

(11) **EP 3 165 362 B1**
(45) Date of publication and mention of the grant of the patent: **29.01.2020**
(21) Application number: 15816027.5
(22) Date of filing: 12.06.2015
(51) Int. Cl.: B41N 3/03, G03F 7/30, G03F 7/40

(54) **LITHOGRAPHIC PRINTING PLATE PROCESSING DEVICE, PLATE-MAKING SYSTEM FOR LITHOGRAPHIC PRINTING PLATES, LITHOGRAPHIC PRINTING PLATE, PROCESSING METHOD FOR LITHOGRAPHIC PRINTING PLATES, AND PRINTING METHOD**
VORRICHTUNG ZUR VERARBEITUNG EINER LITHOGRAPHISCHEN DRUCKPLATTE, PLATTENHERSTELLUNGSSYSTEM FÜR LITHOGRAPHISCHE DRUCKPLATTEN, LITHOGRAPHISCHE DRUCKPLATTE, VERARBEITUNGSVERFAHREN FÜR LITHOGRAPHISCHE DRUCKPLATTEN UND DRUCKVERFAHREN
DISPOSITIF DE TRAITEMENT DE PLAQUES D'IMPRESSION LITHOGRAPHIQUE, SYSTÈME DE FABRICATION DE PLAQUES POUR PLAQUES D'IMPRESSION LITHOGRAPHIQUE, PLAQUE D'IMPRESSION LITHOGRAPHIQUE, PROCÉDÉ DE TRAITEMENT DE PLAQUES D'IMPRESSION LITHOGRAPHIQUE ET PROCÉDÉ D'IMPRESSION

(30) Priority: 02.07.2014 JP 2014136396
(43) Date of publication of application: 10.05.2017
(73) Proprietor: Fujifilm Corporation, Minato-ku Tokyo 106-8620 (JP)
(72) Inventor: WATANABE, Toshihiro, Haibara-gun Shizuoka 421-0396 (JP); WARIISHI, Koji, Haibara-gun Shizuoka 421-0396 (JP)
(74) Representative: Hoffmann Eitle
(86) International application number: PCT/JP2015/067012
(87) International publication number: WO 2016/002477

(56) References cited:
- WO-A1-2008/056506
- JP-A- H1 081 079
- JP-A- 2002 341 558
- JP-A- 2005 024 967
- JP-A- 2005 099 282
- JP-A- 2007 121 449
- JP-A- 2011 177 983
- JP-A- 2011 177 983
- JP-B2- 2 910 951
- JP-B2- 3 607 395
- US-A- 5 368 964

## Description

### BACKGROUND OF THE INVENTION

### 1. Field of the Invention

The present invention relates to a planographic printing plate processing device, a plate-making system of a planographic printing plate, a planographic printing plate, a method of processing a planographic printing plate, and a printing method and particularly relates to a planographic printing plate processing device of a planographic printing plate, a plate-making system of a planographic printing plate, a planographic printing plate, a method of processing a planographic printing plate, and a printing method for newspapers.

### 2. Description of the Related Art

A planographic printing plate is typically formed of a lipophilic image portion that receives ink during a printing process and a hydrophilic non-image portion that receives dampening water. Planographic printing is a printing method of generating a difference in adhesiveness of ink on the surface of a planographic printing plate, impressing the ink only on the image portion, and then transferring the ink to a material to be printed such as paper by setting the lipophilic image portion of the planographic printing plate as an ink receiving unit and the hydrophilic non-image portion as a dampening water receiving unit (ink non-receiving unit) using the property in which water and oily ink repel each other.

In a case where printing is performed using a planographic printing plate, since the end portion of the printing plate is in a position other than paper at the time of printing on paper having a size smaller than the size of the printing plate such as a typical sheet-fed press, the end portion does not affect the print quality. However, in a case where printing is continuously performed on roll-like paper using a rotary press during newspaper printing or the like, since the end portion of the printing plate is on the surface of rolled paper, the ink adhering to the end portion is transferred to the paper and forms linear stain (edge stain) and thus the commodity value of the printed matter is significantly impaired.

As a method of preventing such stain on the end portion during newspaper printing, for example, a method of preventing edge stain by coating the entire surface of a planographic printing plate precursor with a processing liquid so that the planographic printing plate precursor is hydrophilized is known. Further, JP2011-177983A describes that edge stain is prevented by coating the side surface of a planographic printing plate precursor with a processing liquid for hydrophilization. US 5,368,964 relates to a process for the production of a lithographic printing plate, comprising subjecting a lithographic printing plate transported in a predetermined direction by a transporting means to a beveling treatment of end parts thereof and then subjecting the beveled parts to a treatment for rendering hydrophilic.

### SUMMARY OF THE INVENTION

However, in a case where the entire surface of the planographic printing plate precursor is coated with the processing liquid, there is a problem in that the impressing property of printing ink of an image portion is deteriorated and this leads to degradation of the quality of a printed image. Further, the method described in JP2011-177983A has a problem in that the productivity is degraded due to manual application of the processing liquid to the side surface of the planographic printing plate precursor. In recent years, the productivity of an exposure machine has been particularly improved by approximately 180 plates/hour due to technological progress of an exposure machine, but the productivity has not been able to be increased as a whole when it takes time for application of the processing liquid. Moreover, in the method described in JP2011-177983A, in a case where the side surface of the planographic printing plate precursor is coated with the processing liquid in a state in which planographic printing plate precursors are stacked, there is a problem in that the processing liquid is dried so that the planographic printing plate precursors adhere to each other and, accordingly, the planographic printing plate precursors are unlikely to be peeled off from each other when the workability is considered.

The present invention has been made in consideration of the above-described circumstances, and an object thereof is to provide a planographic printing plate processing device that prevents edge stain without degrading the productivity of a planographic printing plate, a plate-making system of a planographic printing plate, a planographic printing plate processed by the planographic printing plate processing device and the plate-making system of a planographic printing plate, a method of processing a planographic printing plate processed by the planographic printing plate processing device and the plate-making system of a planographic printing plate, and a printing method using the planographic printing plate.

In order to achieve the above-described object of the present invention, there is provided a planographic printing plate processing device comprising: a conveyor which conveys a planographic printing plate precursor or a planographic printing plate along a conveyance path; and a coating unit which is provided in the conveyance path and includes coating means for coating a region within 1 cm from an end portion of at least one side of the planographic printing plate precursor or the planographic printing plate with a processing liquid that contains a hydrophilizing agent, and
wherein the coating unit comprises moving means for moving the coating means from a movement start position provided outside or inside of one side end portion of the planographic printing plate precursor or the planographic printing plate to a stopping position provided outside or inside of the planographic printing plate precursor or the planographic printing plate by passing the coating means (20) over the planographic printing plate precursor or the planographic printing plate in a direction perpendicular to the conveyance path of the planographic printing plate precursor or the planographic printing plate.

According to the planographic printing plate processing device of the present invention, since the end portion of at least one side of the planographic printing plate precursor or the planographic printing plate includes the coating unit that applies the processing liquid containing a hydrophilizing agent, the end portion of the planographic printing plate precursor or the planographic printing plate can be automatically coated with the processing liquid. Therefore, it is possible to prevent degradation of the productivity.

The end portion thereof can be coated with the processing liquid using the coating unit by providing the coating unit in the conveyance path that conveys the planographic printing plate precursor or the planographic printing plate while the planographic printing plate precursor or the planographic printing plate is conveyed one by one. Accordingly, the planographic printing plate precursors or the planographic printing plates do not adhere to each other and the productivity is not degraded. Therefore, it is possible to provide a high-quality planographic printing plate.

According to another aspect of the present invention, it is preferable that the planographic printing plate further comprises a processing liquid recovery unit which recovers a waste liquid of the processing liquid.

In this aspect, since the planographic printing plate comprises the processing liquid recovery unit which recovers a waste liquid of the processing liquid, the processing liquid can be used without waste.

According to still another aspect of the present invention, it is preferable that the planographic printing plate processing device further comprises a holding member which holds the planographic printing plate precursor or the planographic printing plate in a stationary state.

In this aspect, since the planographic printing plate precursor or the planographic printing plate can be coated with the processing liquid in a stationary state, the processing liquid can be reliably applied.

According to still another aspect of the present invention, it is preferable that the planographic printing plate processing device further comprises a drying unit which dries the processing liquid applied to the planographic printing plate precursor or the planographic printing plate.

In this aspect, since the planographic printing plate processing device comprises the drying unit which dries the processing liquid, it is possible to prevent the undried processing liquid from adhering to another planographic printing plate precursor or planographic printing plate.

According to still another aspect of the present invention, it is preferable that the coating means is means for bringing a member impregnated with the processing liquid into contact with the planographic printing plate precursor or the planographic printing plate and the processing liquid is applied by bringing the member into contact with the planographic printing plate precursor or the planographic printing plate.

In this aspect, the coating means is limited and the processing liquid can be applied by bringing the member impregnated with the processing liquid into contact with the planographic printing plate precursor or the planographic printing plate.

According to still another aspect of the present invention, it is preferable that the member is any one of felt, sponge, non-woven fabric, and rubber.

The processing liquid can be effectively applied when the above-described member is used as a member impregnated with the processing liquid.

According to another aspect of the present invention, it is preferable that the coating means is processing liquid ejection means.

In this aspect, the coating means is limited and the processing liquid can be applied using the processing liquid ejection means.

According to still another aspect of the present invention, it is preferable that the processing liquid ejection means is any one of an ink-jet type, a dispenser type, and a spray type.

The processing liquid can be effectively applied when the above-described means is used as the processing liquid ejection means.

In this aspect, since the coating unit comprises the moving means which moves the coating means in the direction perpendicular to the conveyance path of the planographic printing plate precursor or the planographic printing plate and the control means for starting and finishing the application, the processing liquid can be provided when the planographic printing plate precursor and the planographic printing plate during conveyance pass through the coating unit and the processing liquid can be efficiently applied.

According to still another aspect of the present invention, it is preferable that the planographic printing plate precursor or the planographic printing plate is of an on-press development type.

In this aspect, the planographic printing plate precursor or the planographic printing plate is limited.

According to still another aspect of the present invention, it is preferable that the planographic printing plate precursor or the planographic printing plate has an image recording layer containing at least an infrared absorbent, a polymerization initiator, a polymerizable compound, and a binder polymer.

According to still another aspect of the present invention, it is preferable that the planographic printing plate precursor or the planographic printing plate has an image recording layer containing at least an infrared absorbent and polymer particles.

According to still another aspect of the present invention, it is preferable that the polymer particle is a thermoplastic resin polymer.

In this aspect, the image recording layer provided for the planographic printing plate precursor or the planographic printing plate is limited and an excellent image can be formed through exposure to light and development using the image recording layer containing the above-described components. Further, when the image recording layer contains polymer particles, the permeability and coating properties of the processing liquid can be improved.

In order to achieve the above-described object of the present invention, there is provided a plate-making system of a planographic printing plate comprising: an exposing unit which imagewise exposes a planographic printing plate precursor; a developing unit which removes an unexposed portion of the planographic printing plate precursor imagewise exposed by the exposing unit; a processor which includes the planographic printing plate processing device described above; and a processing unit which processes at least one of a positioning perforation or a locking piece used for mounting the planographic printing plate precursor processed by the exposing unit and the developing unit on a printing press.

In order to achieve the above-described object of the present invention, there is provided a plate-making system of a planographic printing plate comprising: an exposing unit which imagewise exposes a planographic printing plate precursor; a processor which includes the planographic printing plate processing device described above; and a processing unit which processes at least one of a positioning perforation or a locking piece used for mounting the planographic printing plate on a printing press.

According to the plate-making system of the present invention, since the plate-making system comprises the processor including the above-described planographic printing plate processing device, it is possible to obtain the same effects as those of the above-described planographic printing plate processing device.

According to still another aspect of the present invention, it is preferable that the plate-making system of a planographic printing plate further comprises a printing unit which prints plate information on the planographic printing plate precursor.

In this aspect, since the plate information is printed on the planographic printing plate precursor, it is possible to prevent the planographic printing plate from being erroneously mounted on the plate cylinder of the printing press.

In order to achieve the above-described object of the present invention, there is provided a planographic printing plate which is processed by the planographic printing plate processing device described above.

In order to achieve the above-described object of the present invention, there is provided a planographic printing plate which is prepared by the plate-making system of a planographic printing plate described above.

According to the planographic printing plate of the present invention, since the processing liquid containing a hydrophilizing agent is provided for the end portion of the planographic printing plate, it is possible to prevent adhesion of ink to an end portion and to suppress edge stain. Further, in the application of the processing liquid to the end portion which has been manually performed from the past, non-uniformity resulting from coating unevenness of the processing liquid leads to a variation in edge stain performance or drying failure (stain of the peripheral portion), but the processing liquid can be uniformly and stably applied when the processing liquid is applied through automatic application.

In order to achieve the above-described object of the present invention, there is provided a method of processing a planographic printing plate comprising: processing a planographic printing plate using the planographic printing plate processing device described above.

In order to achieve the above-described object of the present invention, there is provided a method of processing a planographic printing plate comprising: processing a planographic printing plate by the plate-making system of a planographic printing plate described above.

According to the method of processing a planographic printing plate of the present invention, since the processing liquid containing a hydrophilizing agent is provided for the end portion of the planographic printing plate, it is possible to prevent adhesion of ink to an end portion and to suppress edge stain.

In order to achieve the above-described object of the present invention, there is provided a printing method comprising: performing printing with the planographic printing plate described above.

According to the printing method of the present invention, it is possible to perform printing without causing edge stain of the planographic printing plate on printed matter.

It is preferable that the printing method is used for newspapers.

According to the printing method of the present invention, edge stain can be prevented. Since the printing can be performed without adhesion of stain to the edge portion even at the time of printing on paper having a size smaller than the size of the planographic printing plate, the printing method can be suitably used for newspapers.

According to the planographic printing plate processing device, the plate-making system of a planographic printing plate, and the method of processing a planographic printing plate processed by the planographic printing plate processing device and the plate-making system of a planographic printing plate of the present invention, since the processor that coats the end portion of the planographic printing plate precursor or the planographic printing plate with the processing liquid is included, the end portion thereof can be automatically coated with the processing liquid and degradation of the productivity can be prevented. Further, the printing can be performed without causing edge stain by performing printing using the planographic printing plate processing device, the planographic printing plate manufactured by the plate-making system of the planographic printing plate, and the printing method using the planographic printing plate.

### BRIEF DESCRIPTION OF THE DRAWINGS

Fig. 1 is a flowchart showing a process of a plate-making system of a planographic printing plate according to a first embodiment.
Fig. 2 is a view schematically illustrating the entire configuration of the plate-making system of a planographic printing plate according to the first embodiment.
Fig. 3 is a view schematically illustrating the configuration of a coating unit of a planographic printing plate processing device.
Fig. 4 is a flowchart showing a process of a plate-making system of a planographic printing plate according to a second embodiment.
Fig. 5 is a view schematically illustrating the entire configuration of the plate-making system of a planographic printing plate according to the second embodiment.
Fig. 6 is a view schematically illustrating the entire configuration of a plate-making system of a planographic printing plate according to a third embodiment.

### DESCRIPTION OF THE PREFERRED EMBODIMENTS

Hereinafter, a planographic printing plate processing device and a plate-making system of a planographic printing plate according to the present invention will be described with reference to the accompanying drawings. In the present specification, the numerical ranges shown using "to" indicate ranges including the numerical values described before and after "to" as the lower limits and the upper limits. In the present invention, the "planographic printing plate precursor" indicates a "source plate before being exposed" and an "exposed plate" (plate that is not developed) and includes a plate used in a case where plate-making is performed according to an on-press development method. Further, the "planographic printing plate" indicates a "developed plate", that is, a plate which is alkali-developed and on which an image portion and a non-image portion are formed. The position of providing the planographic printing plate processing device of the present invention is not particularly limited in the plate-making system of a planographic printing plate and, accordingly, the planographic printing plate processing device can be processed in any one of the planographic printing plate precursor and the planographic printing plate.

### [Plate-making system of planographic printing plate]

### <First embodiment>

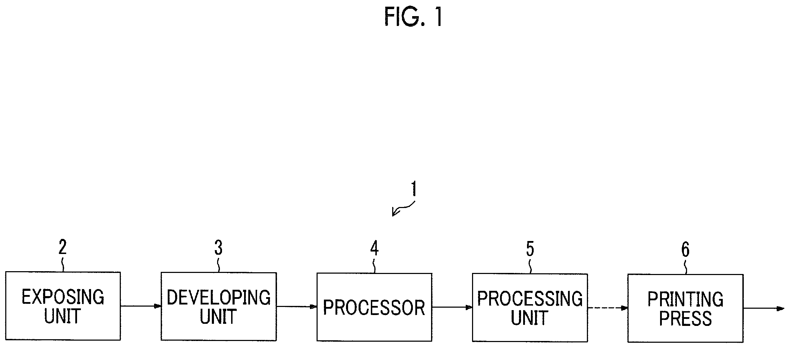

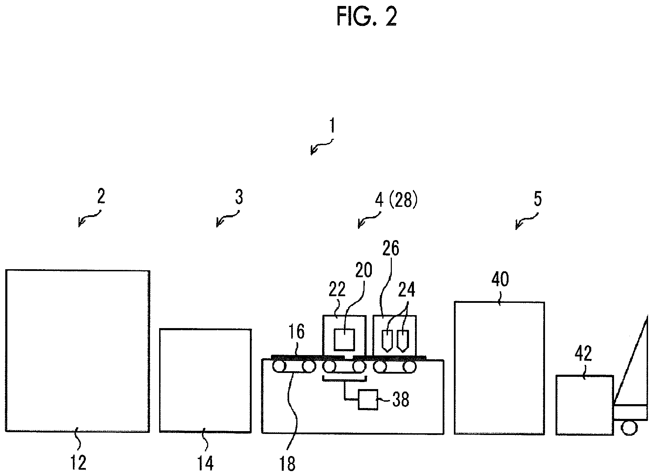

Fig. 1 is a flowchart showing a plate-making process of a plate-making system of a planographic printing plate according to a first embodiment, and Fig. 2 is a view schematically illustrating the entire configuration of the plate-making system of a planographic printing plate.

In a plate-making system 1 of a planographic printing plate according to the first embodiment, the plate-making of a planographic printing plate is performed in order of an exposing unit 2 which imagewise exposes a planographic printing plate precursor, a developing unit 3 which removes an unexposed portion of the planographic printing plate precursor imagewise exposed by the exposing unit 2, a processor 4 which coats the end portion of the planographic printing plate precursor with a processing liquid, and a processing unit 5 which performs processing for mounting the planographic printing plate precursor on a printing press. The planographic printing plate that is made as described above is then conveyed to a printing press 6 and the printing is performed using the planographic printing plate. The order of each configuration in the plate-making system of the planographic printing plate illustrated in Figs. 1 and 2 is merely an example. For example, the processor 4 can be provided after the processing unit 5 and the disposition thereof is not particularly limited.

### <<Exposing unit>>

The planographic printing plate precursor is exposed to an image using the exposing unit 2 by performing exposure through a transparent original image having a line image or a halftone image or laser scanning exposure by digital data. Examples of the exposure light source include a carbon arc, a high pressure mercury lamp, a xenon lamp, a metal halide lamp, a fluorescent lamp, a tungsten lamp, a halogen lamp, an ultraviolet light laser, a visible light laser, and an infrared light laser. A laser is particularly preferable, and examples thereof include a semiconductor laser that emits light in a range of 250 to 420 nm and a solid-state laser and a semiconductor laser that emit infrared rays in a range of 760 to 1400 nm. In a case where a laser is used, it is preferable that scanning exposure is performed on the image according to the digital data. Moreover, in order to shorten the exposure time, it is preferable to use a multi-beam laser device. The exposure mechanism may be any one of an internal drum system, an external drum system, and a flat bed system.

These lasers are used by being mounted on a plate setter 12 illustrated in Fig. 2 which is imagewise exposed through computer control and the imagewise exposure can be performed using the plate setter 12 or the like according to a conventional method.

Examples of the plate setter, among commercially available products, include TrendsetterNews 200 (manufactured by CreoScitex Corp.), NewssetterTH180 (manufactured by KPG Co., Ltd.), Luxel T-9000CTP (manufactured by FUJIFILM Corporation), LaserStar170T (manufactured by Krause Inc.), HS (manufactured by SCREEN Holdings Co., Ltd.), THERMAL SETTER GX9900 (manufactured by Matsushita Electric Industrial Co., Ltd.), THERMAL SETTER Amzisetter (manufactured by NEC Corporation), and THERMAL SETTER (manufactured by CREO CO., LTD.).

Examples of an imagewise exposure method typically include (1) a method of exposing the entire surface of a planographic printing plate material by performing two-dimensional scanning on the planographic printing plate material held by a tabular holding mechanism using one or plural laser beams; (2) a method of exposing the entire surface of a planographic printing plate material by moving the planographic printing plate material in a direction (sub-scanning direction) perpendicular to the circumferential direction while scanning the planographic printing plate material, to the inside of a fixed cylindrical holding mechanism, which is held along the cylindrical surface in the circumferential direction (main scanning direction) of a cylinder using one or plural laser beams from the inside of the cylinder; and (3) a method of exposing the entire surface of a planographic printing plate material by moving the planographic printing plate material in a direction (sub-scanning direction) perpendicular to the circumferential direction while scanning planographic printing plate material held by a cylindrical drum surface rotating about a shaft as a rotary body in a circumferential direction (main scanning direction), through rotation of a drum using one or plural laser beams from the outside of the cylinder.

### <<Developing unit>>

An unexposed portion in the planographic printing plate precursor which is imagewise exposed by the exposing unit 2 is removed by the developing unit 3 using an automatic processor 14. Examples of a wet development method include (1) a development method using an alkali developer (the pH thereof is greater than 10) and (2) a development method using a developer having a pH of 2 to 10.
(1) In the typical developing process using an alkali developer, it is necessary to perform a plurality of processes such as a pre-water washing process for removing a protective layer, if necessary, an alkali developing process, a post-water washing process for removing an alkali, a gumming process for gum processing, and a drying process for drying. An automatic processor or the like described in JP2004-133291A may be exemplified.
(2) In the developing process using a developer having a pH of 2 to 10, the post-water washing process is not particularly necessary and it is preferable that the drying process is performed after developing and gumming are carried out using one liquid. Further, the pre-water washing process is not particularly necessary and it is preferable that developing and gumming are carried out at the same time with removal of a protective layer.

Examples of the automatic processor 14 for wet development include automatic processors, which perform a rubbing process while conveying a planographic printing plate precursor after an image is recorded, described in JP2009-229772A, JP1990-220061A (JP-H02-220061A), and JP1985-59351A (JP-S60-59351A), and automatic processors, which perform a rubbing process on a planographic printing plate precursor after an image set on a cylinder is recorded while rotating the cylinder, described in US5148746A, US5568768A, and British Patent No. 2297719. Among these, an automatic processor using a rotary brush roll as a rubbing member is particularly preferable.

As a commercially available automatic developing machine, LP-1310 News, LP-1310 NewsII, XP-1310 News, and XP-940 News (FUJIFILM Corporation), P-1310 (Kodak Japan Ltd.), AZURA CX-125 (Agfa-Genaert NV), BF-1250 (KONICA MINOLTA, INC.), BlueFin LowChem (Krause-Biagosch GmbH), FCF News (Glunz & JENSEN) can be used.

### <<Processor>>

Next, a region within 1 cm from end portions of at least a set of two sides, facing each other, of the planographic printing plate precursor on which the development process is performed by the developing unit 3 is coated with a processing liquid containing a hydrophilizing agent by the processor 4. When the region of the end portions of the planographic printing plate is coated with the processing liquid, it is possible to prevent adhesion of ink to an end portion of the planographic printing plate. Accordingly, it is possible to prevent edge stain on an end portion of the planographic printing plate at the time of printing.

As illustrated in Fig. 2, the processor 4 is configured of a planographic printing plate processing device 28 that includes a conveyor 18 which is a conveying unit conveying the planographic printing plate precursor 16 along a predetermined conveyance path, a coating unit 22 including coating means 20 for applying the processing liquid, and a drying unit 26 including drying means 24 for drying the processing liquid.

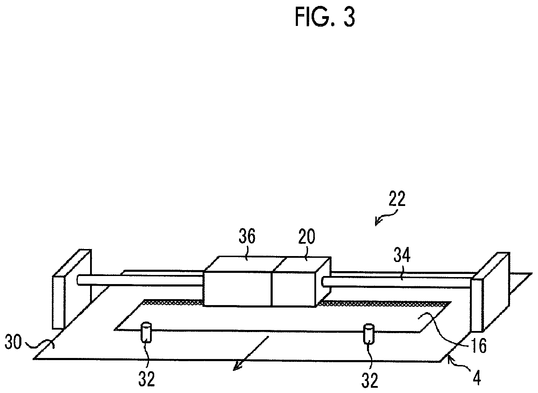

Fig. 3 is a view schematically illustrating the configuration of the coating unit 22. The planographic printing plate precursor 16 is sequentially conveyed from the developing unit 3 by the conveyor 18. A positioning pin 32 is retractably provided on a conveyance surface 30 of the conveyor 18, the positioning pin 32 which is a holding member protrudes from the conveyance surface 30 of the conveyor 18 and the conveyance of the planographic printing plate precursor 16 is stopped and held in a stationary state when the planographic printing plate precursor 16 conveyed from the developing unit 3 is conveyed to a predetermined position of the processor 4, that is, a position of the planographic printing plate precursor 16 where a region coated with the processing liquid is below the coating means 20. In Fig. 3, the planographic printing plate precursor 16 is conveyed in the direction of an arrow in the figure and the rear end of the planographic printing plate precursor 16 is coated with the processing liquid with respect to the conveyance direction of the planographic printing plate precursor 16. Further, even in a case where the front end of the planographic printing plate precursor 16 is coated with the processing liquid, a positioning pin (not illustrated) provided on the conveyance surface 30 protrudes and the conveyance of the planographic printing plate precursor 16 can be stopped and held in a stationary state when the front end of the planographic printing plate precursor 16 is conveyed to a position of the planographic printing plate precursor 16 where a region coated with the processing liquid is below the coating means 20.

The planographic printing plate precursor 16 held by the positioning pin 32 is coated with the processing liquid by the coating means 20. The coating unit 22 comprises moving means for moving the coating means 20 in a direction perpendicular to the conveyance direction of the planographic printing plate precursor 16. Specifically, the coating unit 22 includes a guide rail 34 in a direction perpendicular to the conveyance direction of the planographic printing plate precursor 16 and the coating means 20 is moved to a direction perpendicular to the conveyance direction of the planographic printing plate precursor 16 by being guided by the guide rail 34. The coating means 20 is moved by a driving motor 36 attached to the guide rail 34 together with the coating means 20. The end portion of the planographic printing plate precursor 16 can be coated with the processing liquid by the coating means 20 during the movement in the direction perpendicular to the conveyance direction thereof. Application carried out by the coating means 20 can be performed by moving the coating means in one direction and the application may be performed plural times in a case where the amount of the processing liquid to be applied is small.

When application of the processing liquid to the planographic printing plate precursor 16 is finished, the conveyance of the planographic printing plate precursor 16 is restarted by the positioning pin 32 being settled on the conveyance surface 30. The next planographic printing plate precursor 16 is conveyed to the processor 4 from the developing unit 3 so that the processing liquid is sequentially applied thereto.

The application carried out by the coating means 20 is performed by bringing a member impregnated with the processing liquid into contact with the planographic printing plate precursor 16. Further, the application carried out by the coating means 20 is performed by processing liquid ejection means for ejecting the processing liquid. As the member impregnated with the processing liquid, felt, sponge, non-woven fabric, and rubber can be used. Moreover, the processing liquid is ejected by the processing liquid ejection means using an ink-jet method, a dispenser method, and a spray method. From the viewpoint that deterioration of the coating means can be prevented by coming into contact with the planographic printing plate, it is preferable that the processing liquid is applied using the processing liquid ejection means. As the method of applying the processing liquid by the coating means coming into contact with the planographic printing plate precursor 16, a rubber roller, a stamp, or a lip cream-like solid agent can be used.

In addition, it is preferable that the coating unit 22 comprises control means (not illustrated) for controlling the starting and finish of application along with the movement of the coating means. In a case where the coating means 20 is a member impregnated with the processing liquid, the application is started by lowering the member at the time of passing through one end portion of the planographic printing plate precursor during the movement of the coating means 20 from the movement start position provided outside of one end portion of the planographic printing plate precursor 16 to the stopping position provided outside of another end portion of the planographic printing plate precursor and then bringing the member into contact with the planographic printing plate precursor. Further, the application is finished by elevating the member at the time of passing through another end portion of the planographic printing plate precursor. Moreover, in a case where the coating means is processing liquid ejection means, the processing liquid can be applied only to the planographic printing plate precursor by starting ejection of the processing liquid from the processing liquid ejection means when the coating means 20 passes through one end portion of the planographic printing plate precursor and finishing ejection of the processing liquid from the processing liquid ejection means when the coating means 20 passes through another end portion. In a case where a region contributing to the printing in the planographic printing plate precursor 16 is the entire region of the planographic printing plate precursor 16, it is preferable that the movement start position and the stopping position are provided outside of the planographic printing plate precursor 16.

In a case where the region contributing to the printing is not the entire region of the planographic printing plate precursor 16, the processing liquid may be applied to an end portion of the region contributing to the printing (hereinafter, referred to as a "printing contribution region"). In this case, the movement start position of the coating means 20 is provided in the inside of one end portion of the planographic printing plate precursor 16 and the stopping position is provided in the inside of another end portion of the planographic printing plate precursor. In a case where the coating means 20 is a member impregnated with the processing liquid, the application is started by lowering the member at the time of passing through the printing contribution region of the planographic printing plate precursor during the movement of the coating means 20 from the movement start position to the stopping position and then bringing the member into contact with the planographic printing plate precursor. When the coating means 20 completely passes through the printing contribution region of the planographic printing plate precursor, the application is finished by elevating the member by the coating means 20. Further, in a case where the coating means is processing liquid ejection means, ejection of the processing liquid is started from the processing liquid ejection means when the coating means 20 passes through the printing contribution region of the planographic printing plate precursor. In addition, when the coating means 20 completely passes through the printing contribution region of the planographic printing plate precursor, the processing liquid can be applied to the printing contribution region of the planographic printing plate precursor by finishing ejection of the processing liquid.

The planographic printing plate precursor 16 for which the processing liquid is provided by the coating unit 22 is then conveyed to the drying unit 26. The processing liquid applied by the coating unit 22 is dried by the drying unit 26.

The processing liquid can be dried using a known method. Fig. 2 illustrates the configuration provided with a dry air blow nozzle that supplies dry air as the drying means 24. The drying means 24 is not limited thereto and the processing liquid can be dried using an air knife, induction heating (IH), lamp drying, and ultraviolet (UV) light sources. Among these, it is preferable that the drying is performed by hot air drying.

Moreover, the planographic printing plate processing device 28 comprises a processing liquid recovery unit 38 that recovers a waste liquid of the processing liquid. The processing liquid recovery unit 38 recovers the processing liquid which is excessively applied to the planographic printing plate precursor 16 by the coating unit 22.

### <<Processing unit>>

In order to mount the planographic printing plate on the plate cylinder of a rotary press for newspapers, at least one of a positioning perforation for positioning or a locking piece for bending the edge facing the planographic printing plate to have a predetermined shape for attachment is formed on the edge by the processing unit 5. Moreover, the "positioning perforation" indicates a hole formed on a non-image portion of the planographic printing plate for attaching the planographic printing plate to the plate cylinder and the "locking piece" indicates a locking portion formed by performing a bending process on the edge of the planographic printing plate to have a predetermined shape for attaching the planographic printing plate to the plate cylinder.

The processing unit 5 comprises an illumination light source and an imaging apparatus. Since the processing positions of the positioning perforation and the locking piece are determined based on a position of a reference mark formed on the planographic printing plate precursor, the position of the reference mark needs to be detected with high precision in order to determine the processing positions of the positioning perforation and the locking piece with high precision. As a method of forming the reference mark on the planographic printing plate, the reference mark can be formed by performing development using a developer after imagewise exposure. Preferred examples of the developer used for forming the reference mark include an alkaline developer and a gum developer. As the gum developer, the "rubber solution" described in paragraphs [0016] to [0028] of JP2007-538279A can be used.

In regard to the reference mark, a polarizing plate and a phase difference plate having a quarter wavelength are disposed between the illumination light source and the planographic printing plate precursor and between the imaging apparatus and the planographic printing plate precursor, the periphery of the reference mark position of the planographic printing plate precursor is irradiated with light using the illumination light source, and the reference mark is imaged by the imaging apparatus. Position information of the reference mark is detected from the captured image and the positioning perforation and /or the locking piece is processed based on the position information.

As a printing plate processing device that processes the positioning perforation and/or the locking piece, a punch bender 40 can be used. For example, a punch bender SIBM-V40 (manufactured by Shimizu Production Co., Ltd.) can be suitably used as a commercially available punch bender. Further, as a processing device used in the present embodiment, a printing plate processing device which is capable of processing both of the positioning perforation and the locking piece is preferable.

The method of processing the positioning perforation and the locking piece is not particularly limited and a known method can be used. The methods described in JP2010-89384A may be exemplified.

The planographic printing plate precursor 16 in which the positioning perforation and/or the locking piece is processed by the processing unit 5 is laminated on a stocker 42.

According to the planographic printing plate processing device and the plate-making system of a planographic printing plate of the present embodiment, since the planographic printing plate precursor 16 conveyed from the developing unit 3 by the conveyor 18 can be automatically coated with the processing liquid using the planographic printing plate processing device 28, degradation of the productivity can be prevented. Further, since the planographic printing plate precursor 16 conveyed one by one is coated with the processing liquid, adhesion between the planographic printing plate precursors 16 can be prevented by the processing liquid.

According to the planographic printing plate processed by the planographic printing plate processing device, the planographic printing plate processed by the plate-making system of a planographic printing plate, and the printing method using this planographic printing plate of the present embodiment, since ink does not adhere to an end portion of the planographic printing plate at the time of printing, edge stain of the planographic printing plate can be suppressed. Further, the edge stain can be suppressed and thus the planographic printing plate for newspapers with the printed matter larger than a planographic printing plate can be suitably used.

### [Processing liquid]

Next, the processing liquid applied to an end portion of the planographic printing plate precursor by the planographic printing plate processing device 28 will be described. The processing liquid contains a hydrophilizing agent and examples of the hydrophilizing agent include a low-molecular weight hydrophilic compound, a surfactant, a phosphoric acid compound, a phosphonic acid compound, and a water-soluble resin.

### {Low-molecular weight hydrophilic compound}

As a water-soluble organic compound, examples of the low-molecular weight hydrophilic compound include glycols such as ethylene glycol, diethylene glycol, triethylene glycol, propylene glycol, dipropylene glycol, and tripropylene glycol and ether or ester derivatives thereof; polyols such as glycerin, pentaerythritol, and tris(2-hydroxyethyl) isocyanurate; organic amines such as triethanolamine, diethanolamine, and monoethanolamine and salts thereof; organic sulfonic acids such as alkylsulfonic acid, toluenesulfonic acid, and benzenesulfonic acid and salts thereof; organic sulfamic acids such as alkyl sulfamic acid and salts thereof; organic sulfuric acids such as alkyl sulfuric acid and alkyl ether sulfuric acid and salts thereof; organic phosphonic acids such as phenyl phosphonic acid and salts thereof; organic carboxylic acids such as tartaric acid, oxalic acid, citric acid, malic acid, lactic acid, gluconic acid, and amino acids and salts thereof; and betaines.

In the present invention, among these, it is preferable that the processing liquid contains at least one selected from the group consisting of polyols, organic sulfates, organic sulfonates, and betaines.

Specific examples of the compounds of the organic sulfonates include alkyl sulfonate such as sodium n-butyl sulfonate, sodium n-hexyl sulfonate, sodium 2-ethyl hexyl sulfonate, sodium cyclohexyl sulfonate, or sodium n-octyl sulfonate; alkyl sulfonate having an ethylene oxide chain such as sodium 5,8,11-trioxapentadecane-1-sulfonate, sodium 5,8,11-trioxaheptadecane-1-sulfonate, sodium 13-ethyl-5,8,11-trioxaheptadecane-1-sulfonate, or sodium 5,8,11,14-tetraoxatetradecosane-1-sulfonate; aryl sulfonate such as sodium benzene sulfonate, sodium p-toluene sulfonate, sodium p-hydroxy benzene sulfonate, sodium p-styrene sulfonate, sodium isophthalic acid dimethyl-5-sulfonate, sodium 1-naphthyl sulfonate, sodium 4-hydroxynaphthyl sulfonate, disodium 1,5-naphthalene disulfonate, or trisodium 1,3,6-naphthalene trisulfonate; and compounds described in paragraphs [0026] to [0031] of JP2007-276454A and paragraphs [0020] to [0047] of JP2009-154525A. The salt may be potassium salt or lithium salt.

Examples of the organic sulfate include sulfate of alkyl, alkenyl, alkynyl, aryl, or heterocyclic monoether of polyethylene oxide. The unit of ethylene oxide is preferably 1 to 4 and it is preferable that the salt is sodium salt, potassium salt, or lithium salt. Specific examples of these include compounds described in paragraphs [0034] to [0038] of JP2007-276454A.

As betaines, compounds having 1 to 5 carbon atoms of hydrocarbon substituents to nitrogen atoms are preferable. Specific examples thereof include trimethyl ammonium acetate, dimethyl propyl ammonium acetate, 3-hydroxy-4-trimethyl ammonio butyrate, 4-(1-pyridinio)butyrate, 1-hydroxyethyl-1-imidazolioacetate, trimethyl ammonium methane sulfonate, dimethyl propyl ammonium methane sulfonate, 3-trimethylammonio-1-propane sulfonate, and 3-(1-pyridinio)-1-propane sulfonate.

Since the above-described low-molecular weight hydrophilic compound has a small structure of a hydrophobic portion and almost does not have a surface active action, hydrophobicity or film strength of an image portion is not degraded by dampening water permeating into an image recording layer exposing unit (image portion) and ink receptivity or printing durability of the image recording layer can be maintained satisfactorily.

The amount of these low-molecular weight hydrophilic compounds to be added to the image recording layer is preferably in a range of 0.5% by mass to 20% by mass with respect to the total amount of the solid content in the image recording layer. The amount thereof is more preferably in a range of 1% by mass to 15% by mass and still more preferably in a range of 2% by mass to 10% by mass. When the amount thereof is in the above-described range, excellent on-press developability and printing durability can be obtained.

These compounds may be used alone or in combination of two or more kinds thereof.

### {Surfactants}

Examples of surfactants include anionic surfactants, non-ionic surfactants, cationic surfactants, and amphoteric surfactants. Among these, anionic surfactants and/or non-ionic surfactants are preferable. In a case where an anionic surfactant and/or a non-ionic surfactant is used, a processing liquid having excellent coating properties can be obtained.

Further, fluorine-based or silicone-based anionic or non-ionic surfactants (typically, fluorine-based or silicone-based anionic or non-ionic surfactants) are not preferable as the anionic surfactant or non-ionic surfactant of the present embodiment. Since the coating properties of the processing liquid are degraded, it is not preferable to use these surfactants.

Examples of the anionic surfactants include fatty acid salts, abietates, hydroxy alkane sulfonates, alkane sulfonates, dialkyl sulfosuccinates, linear alkyl benzene sulfonates, branched alkyl benzene sulfonates, alkyl naphthalene sulfonates, alkyl phenoxy polyoxyethylene propyl sulfonates, polyoxyethylene aryl ether sulfuric acid ester salts, polyoxyethylene alkyl sulfophenyl ether salts, N-methyl-N-oleyl sodium taurines, N-alkyl sulfosuccinic acid monoamide disodium salts, petroleum sulfonic acid salts, sulfated castor oil, sulfated beef tallow oil, sulfuric acid ester salts of fatty acid alkyl ester, alkyl sulfuric acid ester salts, polyoxyethylene alkyl ether sulfuric acid ester salts, fatty acid monoglyceride sulfuric acid ester salts, polyoxyethylene alkyl phenyl ether sulfuric acid ester salts, polyoxyethylene styryl phenyl ether sulfuric acid ester salts, alkyl phosphoric acid ester salts, polyoxyethylene alkyl ether phosphoric acid ester salts, polyoxyethylene alkyl phenyl ether phosphoric acid ester salts, partially saponified products of a styrene-maleic anhydride copolymer, partially saponified products of an olefin-maleic anhydride copolymer, and naphthalene sulfonate formalin condensates. Among these, dialkyl sulfosuccinates, alkyl sulfonic acid ester salts, polyoxyethylene aryl ether sulfonic acid ester salts, and alkyl naphthalene sulfonates are particularly preferable.

Specifically, at least one anionic surfactant selected from the group consisting of anionic surfactants represented by Formula (I-A) or (I-B) may be exemplified.

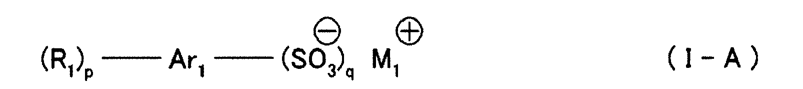

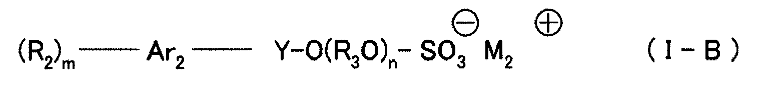

In the above-described Formula (I-A), R₁ represents a linear or branched alkyl group having 1 to 20 carbon atoms; p represents 0, 1, or 2; An represents an aryl group having 6 to 10 carbon atoms; q represents 1, 2, or 3; and M₁⁺ represents Na⁺, K⁺, Li⁺, or NH₄⁺. When p represents 2, a plurality of R₁'s may be the same as or different from each other.

In the above-described Formula (I-B), R₂ represents a linear or branched alkyl group having 1 to 20 carbon atoms; m represents 0, 1, or 2; Ar₂ represents an aryl group having 6 to 10 carbon atoms; Y represents a single bond or an alkylene group having 1 to 10 carbon atoms; R₃ represents a linear or branched alkylene group having 1 to 5 carbon atoms; n represents an integer of 1 to 100; and M₂⁺ represents Na⁺, K⁺, Li⁺, or NH₄⁺. When m represents 2, a plurality of R₂'s may be the same as or different from each other. When n represents 2 or greater, a plurality of R₃'s may be the same as or different from each other.

According to a preferred embodiment of the present invention, preferred examples of R₁ and R₂ in the above-described Formulae (I-A) and (I-B) include CH₃, C₂H₅, C₃H₇, and C₄H₉. Further, preferred examples of R₃ include -CH₂-, -CH₂CH₂-, -CH₂CH₂CH₂-, and -CH₂CH(CH₃)-. Among these, -CH₂CH₂- is more preferable. Moreover, it is preferable that p and m represent 0 or 1 and particularly preferable that p represents 0. It is preferable that Y represents a single bond. Further, it is preferable that n represents an integer of 1 to 20.

Specific examples of the compounds represented by Formula (I-A) or (I-B) include the following compounds.

| | | | |
|---|---|---|---|
| (1) | 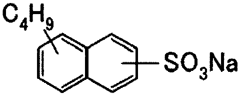 | (10) | 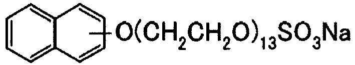 |
| (2) | 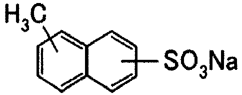 | (11) | 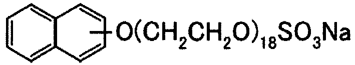 |
| (3) | 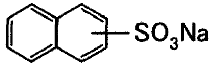 | (12) | 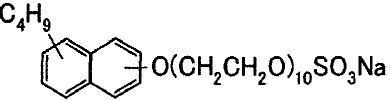 |
| (4) | 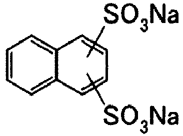 | (13) | 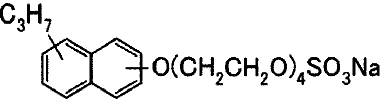 |
| (5) | 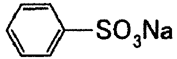 | (14) | 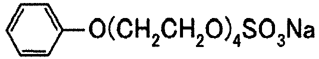 |
| (6) | 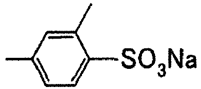 | (15) | 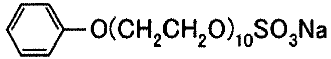 |
| (7) | 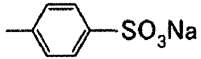 | (16) | 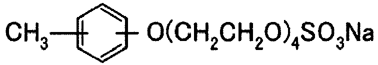 |
| (8) | 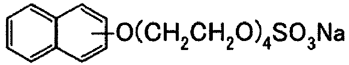 | (17) | 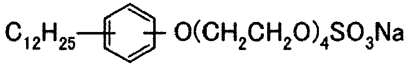 |
| (9) | 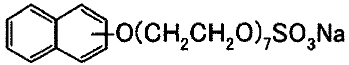 | | |

Examples of the non-ionic surfactants include polyoxyethylene alkyl ethers, polyoxyethylene aryl ethers, glycerin fatty acid partial esters, sorbitan fatty acid partial esters, pentaerythritol fatty acid partial esters, propylene glycol mono-fatty acid ester, sucrose fatty acid partial ester, polyoxyethylene sorbitan fatty acid partial esters, polyoxyethylene sorbitol fatty acid partial esters, polyethylene glycol fatty acid esters, polyglycerin fatty acid partial esters, polyoxyethylene glycerin fatty acid partial esters, fatty acid diethanol amides, N,N-bis-2-hydroxyalkylamines, polyoxyethylene alkylamine, triethanolamine fatty acid ester, and trialkyl amine oxide. Among these, polyoxyethylene aryl ethers and polyoxyethylene-polyoxypropylene block copolymers are preferable.

Preferred examples of other surfactants used for the processing liquid include non-ionic surfactants, for example, polyoxyethylene alkyl ethers such as polyoxyethylene naphthyl ether, polyoxyethylene alkyl phenyl ether, polyoxyethylene lauryl ether, polyoxyethylene cetyl ether, and polyoxyethylene stearyl ether; polyoxyethylene alkyl esters such as polyoxyethylene stearate; sorbitan alkyl esters such as sorbitan monolaurate, sorbitan monostearate, sorbitan distearate, sorbitan monooleate, sorbitan sesquioleate, and sorbitan trioleate; and monoglyceride alkyl esters such as glycerol monostearate and glycerol monooleate.

Preferred examples of the non-ionic surfactant include surfactants represented by the following Formula (II-A) and surfactants represented by the following Formula (II-B).

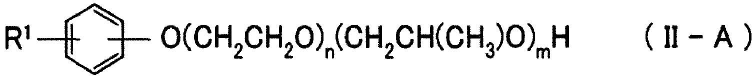

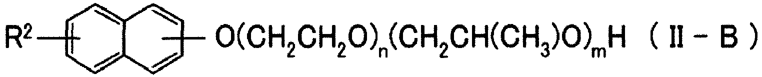

(In the above-described Formula (II-A), R¹ represents a hydrogen atom or an alkyl group having 1 to 100 carbon atoms. n and m each represent an integer of 0 to 100 and both of n and m do not represent 0.

In the above-described Formula (II-B), R₂ represents a hydrogen atom or an alkyl group having 1 to 100 carbon atoms. n and m each represent an integer of 0 to 100 and both of n and m do not represent 0.)

Examples of the compound represented by Formula (II-A) include polyoxyethylene phenyl ether, polyoxyethylene methyl phenyl ether, polyoxyethylene octyl phenyl ether, and polyoxyethylene nonyl phenyl ether. Examples of the compound represented by Formula (II-B) include polyoxyethylene naphthyl ether, polyoxyethylene methyl naphthyl ether, polyoxyethylene octyl naphthyl ether, and polyoxyethylene nonyl naphthyl ether.

In the compounds represented by the above-described Formulae (II-A) and (II-B), the number (n) of repeating units of the polyoxyethylene chain is preferably in a range of 3 to 50 and more preferably in a range of 5 to 30. The number (m) of repeating units of the polyoxypropylene chain is preferably in a range of 0 to 10 and more preferably in a range of 0 to 5. The polyoxyethylene portion and the polyoxypropylene portion may be random copolymers or block copolymers.

The non-ionic aromatic ether-based surfactants represented by the above-described Formulae (II-A) and (II-B) may be used alone or in combination of two or more kinds thereof.

Specific examples of compounds represented by the following Formulae (II-A) and (II-B) are described below. Moreover, the oxyethylene repeating unit and oxypropylene repeating unit in the following exemplary compound "Y-5" may be in the form of any one of a random bond and block connection.

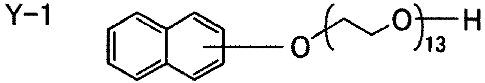

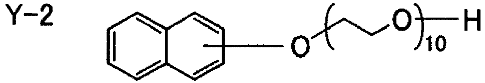

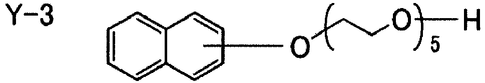

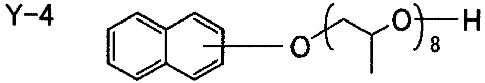

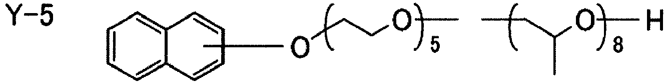

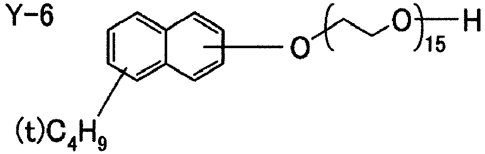

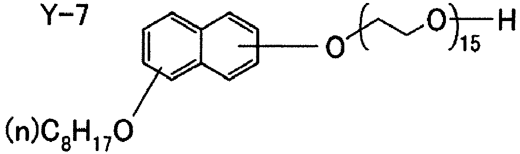

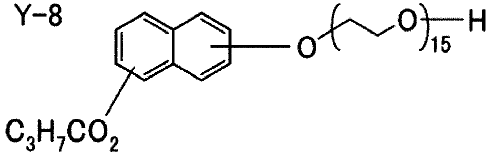

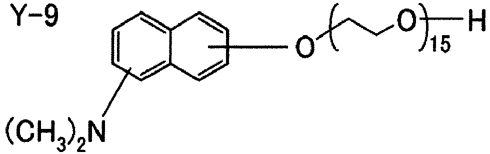

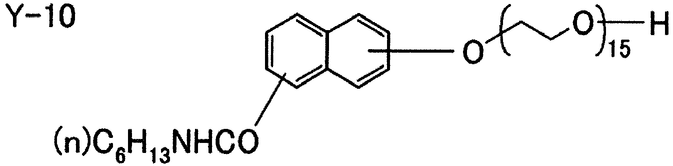

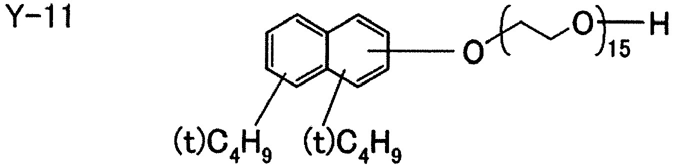

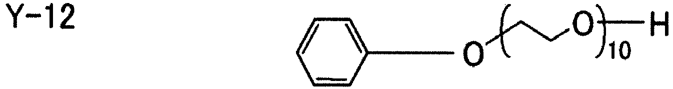

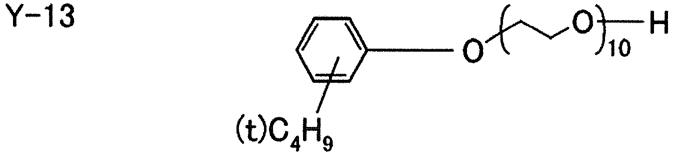

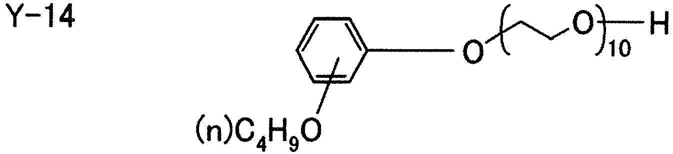

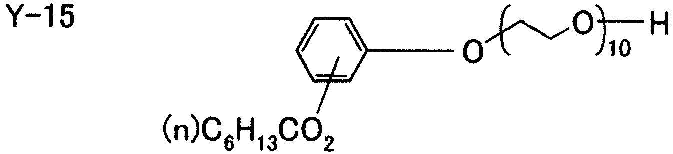

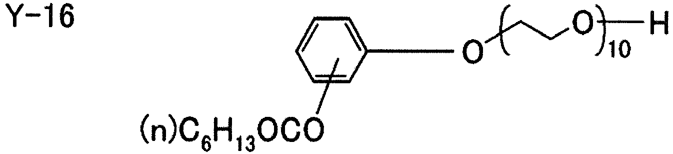

Among the above-described surfactants, anionic surfactants which are highly effective in promoting on-press development are particularly preferably used, and these surfactants can be used in combination of two or more kinds thereof. For example, a combination of two or more kinds of anionic surfactants which are different from each other or a combination of an anionic surfactant and a non-ionic surfactant is preferable.

It is preferable to use sodium naphthalene sulfonate, sodium alkyl naphthalene sulfonate, or polyoxyethylene aryl ether and more preferable to use sodium naphthalene sulfonate or sodium t-butyl naphthalene sulfonate.

The amount of the above-described surfactant to be used does not need to be particularly limited, but is preferably in a range of 0.01% to 20% by mass, more preferably in a range of 0.5% to 15% by mass, and still more preferably in a range of 1.0% to 10% by mass with respect to the total mass of the processing liquid. In a case where the amount of the surfactant to be used is in the above-described range, the on-press developability is promoted.

In addition, known cationic surfactants or amphoteric surfactants of the related art can be used in combination. Examples of the cationic surfactants include alkylamine salts, quartenary ammonium salts, polyoxyalkylene alkylamine salts, and polyethylene polyamine derivatives. Examples of the amphoteric surfactants used in the present invention include carboxyl betaines, amino carboxylic acids, sulfobetaines, amino sulfuric acid esters, and imidazolines.

### {Phosphate compound}

Examples of the phosphate compound include phosphoric acid, metaphosphoric acid, ammonium primary phosphate, ammonium secondary phosphate, sodium dihydrogen phosphate, sodium monohydrogen phosphate, potassium primary phosphate, potassium secondary phosphate, sodium tripolyphosphate, potassium pyrophosphate, and sodium hexametaphosphate. Among these, sodium dihydrogen phosphate, sodium monohydrogen phosphate, or sodium hexametaphosphate can be suitably used.

The content of the phosphate compound is preferably in a range of 0.5% to 3.0% by mass and more preferably in a range of 0.5% to 2.5% by mass with respect to the total mass of the processing liquid. When the content thereof is in the above-described range, a processing liquid which is excellent in suppressing crystal precipitation after coating can be obtained.

### {Phosphonate compound}

Examples of the phosphonate compound include ethylphosphonate, propylphosphonate, i-propylphosphonate, butylphosphonate, hexylphosphonate, octylphosphonate, dodecylphosphonate, octadecylphosphonate, 2-hydroxyethyl phosphonate and sodium salts or potassium salts of these, alkyl phosphonic acid monoalkyl ester such as methylphosphonic acid methyl ester, ethylphosphonic acid methyl ester, or methyl 2-hydroxyethyl phosphonic acid and sodium salts or potassium salts of these, alkylene diphosphonic acid such as methylene diphosphonic acid or ethylene diphosphonic acid and sodium salts or potassium salts of these, and polyvinyl phosphonic acid. Among these, polyvinyl phosphonic acid is preferably used.

The content of the phosphonic acid compound is preferably in a range of 0.5% to 3.0% by mass and more preferably in a range of 0.5% to 2.5% by mass with respect to the total mass of the processing liquid. When the content thereof is in the above-described range, a processing liquid which is excellent in suppressing crystal precipitation after coating can be obtained.

### {Water-soluble resin}

Examples of the water-soluble resin include water-soluble resins classified as polysaccharides, polyvinyl alcohol, polyvinyl pyrrolidone, polyacrylamide, and copolymers thereof, a vinyl methyl ether/maleic anhydride copolymer, a vinyl acetate/maleic anhydride copolymer, and a styrene/maleic anhydride copolymer.

Examples of the polysaccharides include starch derivatives (such as dextrin, enzymatically decomposed dextrin, hydroxypropylated starch, carboxymethylated starch, phosphoric acid esterified starch, polyoxyalkylene grafted starch, and cyclodextrin); celluloses (such as carboxymethyl cellulose, carboxyethyl cellulose, methyl cellulose, hydroxypropyl cellulose, and methylpropyl cellulose); carrageenan, alginic acid, guar gum, locust bean gum, xanthan gum, gum Arabic, and soybean polysaccharides.

Among these, starch derivatives such as dextrin and polyoxyalkylene grafted starch, gum arabic, carboxymethyl cellulose, and soybean polysaccharides are preferably used.

These water-soluble resins can be used in combination of two or more kinds thereof and the content thereof is preferably in a range of 5% to 40% by mass and more preferably in a range of 10% to 30% by mass with respect to the total mass of the processing liquid. When the content thereof is in the above-described range, the processing liquid can be applied excellently without difficulty due to high viscosity of the processing liquid.

### {Organic solvent}

In addition, it is preferable that the processing liquid further contains an organic solvent. Examples of the organic solvent include an alcohol-based solvent, a ketone-based solvent, an ester-based solvent, an amide-based solvent, and a hydrocarbon-based solvent. Among these, an alcohol-based solvent and a hydrocarbon-based solvent are preferable.

The organic solvent may be used alone or in combination of two or more kinds thereof. The amount of the organic solvent to be used is preferably in a range of 0.5% to 10% by mass and more preferably in a range of 1% to 5% by mass with respect to the total mass of the processing liquid. When the content thereof is in the above-described range, the portion coated with the processing liquid does not become sticky and the permeability of the processing liquid into the image recording layer is excellent.

### {Plasticizer}

Further, the processing liquid may contain a plasticizer. Examples of the plasticizer include plasticizers having a freezing point of 15°C or lower, for example, phthalic acid diesters such as dibutyl phthalate, diheptyl phthalate, di-n-octyl phthalate, di(2-ethylhexyl) phthalate, dinonyl phthalate, didecyl phthalate, dilauryl phthalate, and butyl benzyl phthalate; aliphatic dibasic acid esters such as dioctyl adipate, butyl glycol adipate, dioctyl azelate, dibutyl sebacate, di(2-ethylhexyl) sebacate, and dioctyl sebacate; epoxidized triglycerides such as epoxidized soybean oil; phosphoric acid esters such as tricresyl phosphate, trioctyl phosphate, and trischloroethyl phosphate; and benzoic acid esters such as benzyl benzoate.

The plasticizer may be used alone or in combination of two or more kinds thereof. The amount of plasticizer to be used is preferably in a range of 0% to 10% by mass and more preferably in a range of 0% to 5% by mass with respect to the total mass of the processing liquid.

### {Other optional components}

The processing liquid that processes an end portion of the planographic printing plate precursor may contain inorganic salts such as nitrate and sulfate, a preservative, and an anti-foaming agent in addition to the above-described components.

### [Planographic printing plate precursor and planographic printing plate]

The shape of the planographic printing plate precursor or the planographic printing plate used in the present invention is not particularly limited, but it is preferable that the planographic printing plate precursor or the planographic printing plate is formed to have a rectangular shape and has at least a support and an image recording layer. Moreover, the "rectangular shape" means that the planographic printing plate precursor or the planographic printing plate has at least four sides. That is, a substrate may have corners trimmed in an arc shape or may be angular. Further, straight lines shorter than the four sides may be provided thereon.

### [Image recording layer]

The image recording layer indicates a layer formed with an image in which a hydrophobic region is formed by exposure to infrared rays and the hydrophobic region becomes an ink receiving portion.

Examples of typical embodiments of an image recording layer include (1) an embodiment in which an image recording layer contains an infrared absorbent, a polymerization initiator, a polymerizable compound, and a binder polymer and an image portion is formed using polymerization reaction and (2) an embodiment in which an image recording layer contains an infrared absorbent and polymer particles and a hydrophobic region (image portion) is formed using thermal fusion or a thermal reaction of polymer particles. Further, the above-described two embodiments may be mixed. For example, (1) a polymerization type image recording layer may contain polymer particles or (2) a polymer particle type image recording layer may contain polymerizable compound. Among these, an embodiment in which a polymerization type image recording layer contains an infrared absorbent, a polymerization initiator, and a polymerizable compound is preferable and an embodiment in which an image recording layer contains an infrared absorbent, a polymerization initiator, a polymerizable compound, a binder polymer, and/or polymer particles is more preferable.

Hereinafter, an infrared absorbent, polymer particles, and a binder polymer which are indispensable components of the image recording layer will be sequentially described.

### {Infrared absorbent}

An infrared absorbent has a function of converting absorbed infrared rays into heat and/or a function of electron transfer to a polymerization initiator described below through excitation by infrared rays and/or a function of energy transfer. The infrared absorbent used in the present embodiment is a dye having maximum absorption at a wavelength of 760 to 1,200 nm.

As the infrared absorbent, commercially available dyes and known dyes described in the literatures such as "Dye Handbook" (edited by The Society of Synthetic Organic Chemistry, Japan, published in 1970) can be used. Specific examples thereof include an azo dye, a metal complex salt azo dye, a pyrazolone azo dye, a naphthoquinone dye, an anthraquinone dye, a phthalocyanine dye, a carbonium dye, a quinone imine dye, a methine dye, a cyanine dye, a squarylium dye, a pyrylium salt, and a metal thiolate complex.

Among the above-described dyes, a cyanine dye, a squarylium dye, a pyrylium salt, a nickel thiolate complex, and an indolenine cyanine dye are particularly preferable. Further, a cyanine dye or an indolenine cyanine dye is preferable.

Specific examples of the cyanine dye which can be suitably used include compounds described in paragraphs 0017 to 0019 of JP2001-133969A and compounds described in paragraphs 0016 to 0021 of JP2002-023360A and paragraphs 0012 to 0037 of JP2002-040638A. Preferred examples thereof include compounds described in paragraphs 0034 to 0041 of JP2002-278057A and paragraphs 0080 to 0086 of JP2008-195018A and most preferred examples thereof include compounds described in paragraphs 0035 to 0043 of JP2007-90850A.

Further, compounds described in paragraphs 0008 and 0009 of JP1993-5005A (JP-H05-5005A) and compounds described in paragraphs 0022 to 0025 of JP2001-222101A can be preferably used.

In addition, these infrared absorbents may be used alone or in combination of two or more kinds thereof. Further, a combination of infrared absorbents other than the infrared absorbents such as pigments may be used. As the pigments, compounds described in paragraphs 0072 to 0076 of JP2008-195018A are preferable.

The content of the infrared absorbent in the image recording layer of the present invention is preferably in a range of 0.1% to 10.0% by mass and more preferably in a range of 0.5% to 5.0% by mass with respect to the total solid content of the image recording layer.

### {Polymer particles}

Polymer particles indicate fine particles which is capable of converting the image recording layer into a hydrophobic layer when heat is applied thereto. The volume average particle diameter of the polymer particles used in the present embodiment is preferably in a range of 0.01 to 3.0 µm. As the fine particles, at least one selected from a hydrophobic thermoplastic resin polymer, a thermally reactive fine particle polymer, a fine particle polymer having a polymerizable group, a microcapsule encapsulating a hydrophobic compound, and a microgel (cross-linked fine particle polymer) is preferable. Among these, a fine particle polymer having a polymerizable group, a hydrophobic thermoplastic resin polymer, and a microgel are preferable; a hydrophobic thermoplastic resin polymer and a microgel are more preferable; and a microgel is still more preferable.

### [Hydrophobic thermoplastic resin polymer]

Preferred examples of the hydrophobic thermoplastic resin polymer include hydrophobic thermoplastic resin polymers described in Research Disclosure No. 333003 on January, 1992, JP1997-123387A (JP-H09-123387A), JP1997-131850A (JP-H09-131850A), JP1997-171249A (JP-H09-171249A), JP1997-171250A (JP-H09-171250A), and EP931647B.

Specific examples of a polymer constituting such a hydrophobic thermoplastic resin polymer include homopolymers or copolymers of monomers such as acrylate or methacrylate having structures of ethylene, styrene, vinyl chloride, methyl acrylate, ethyl acrylate, methyl methacrylate, ethyl methacrylate, vinylidene chloride, acrylonitrile, vinyl carbazole, and polyalkylene, and mixtures of these. Among these, polystyrene, styrene, a copolymer containing acrylonitrile, and methyl polymethacrylate are more preferable.

The volume average particle diameter of the hydrophobic thermoplastic resin polymer used in the present invention is preferably in a range of 0.01 to 3.0 µm.

### [Thermally reactive fine particle polymer]

Examples of the thermally reactive fine particle polymer include fine particle polymers having a thermally reactive group. These polymers are cross-linked by a thermal reaction and have hydrophobic regions formed by a change in functional groups during the crosslinking.

As the thermally reactive group in a fine particle polymer having a thermally reactive group used in the present embodiment, a functional group that performs any reaction may be used as long as a chemical bond is formed, but a polymerizable group is preferable. Preferred examples of the polymerizable group include an ethylenically unsaturated group that performs a radical polymerization reaction (such as an acryloyl group, a methacryloyl group, a vinyl group, or an allyl group); a cationic polymerizable group (such as a vinyl group, a vinyloxy group, an epoxy group, or an oxetanyl group); an isocyanate group that performs an addition reaction or a block body thereof, an epoxy group, a vinyloxy group, and a functional group having active hydrogen atoms as the reaction partners of these (such as an amino group, a hydroxyl group, or a carboxyl group); a carboxyl group that performs a condensation reaction and a hydroxyl group or an amino group as a reaction partner thereof; and an acid anhydride that performs a ring opening addition reaction and an amino group or a hydroxyl group as a reaction partner thereof.

### "Microcapsule"

The microcapsule is a microcapsule in which all or a part of constituent components of the image recording layer are encapsulated as described in JP2001-277740A and JP2001-277742A. Further, the constituent components of the image recording layer may be contained in a portion other than the microcapsule. Moreover, a preferred embodiment of the image recording layer containing the microcapsule is an embodiment in which hydrophobic constituent components are encapsulated by a microcapsule and hydrophilic constituent components are contained by a portion other than the microcapsule.

A known method can be used as a method of preparing the microcapsule.

The volume average particle diameter of the microcapsule is preferably in a range of 0.01 to 3.0 µm, more preferably in a range of 0.05 to 2.0 µm, and particularly preferably in a range of 0.10 to 1.0 µm. When the volume average particle diameter thereof is in the above-described range, excellent resolution and temporal stability can be obtained.

### [Microgel]

The microgel indicates reactive or non-reactive resin particles dispersed in an aqueous medium. From the viewpoints of image forming sensitivity and printing durability, it is preferable that the microgel contains a polymerizable group in the particles thereof or preferably on the surface of the particles to obtain a reactive microgel.

A known method can be used as a method of preparing a microgel.

A preferable microgel used in the present embodiment has crosslinking reactivity. From this viewpoint, it is preferable that materials such as polyurea, polyurethane, polyester, polycarbonate, polyamide, and a mixture of these are used. Among these, polyurea and polyurethane are more preferable and polyurethane is particularly preferable.

The volume average particle diameter of the microgel is preferably in a range of 0.01 to 3.0 µm, more preferably in a range of 0.05 to 2.0 µm, and particularly preferably in a range of 0.10 to 1.0 µm. When the volume average particle diameter is in the above-described range, excellent crosslinking properties and temporal stability can be obtained.

The content of the polymer particles is preferably in a range of 5% to 90% by mass with respect to the total solid content of the image recording layer.

### {Binder polymer}

A binder polymer can be used to improve the film strength of the image recording layer. As the binder polymer, known polymers of the related art can be used without limitation and polymers having coated-film properties are preferable. Among examples thereof, an acrylic resin, a polyvinyl acetal resin, and a polyurethane resin are preferable.

Moreover, the binder polymer of the present invention does not contain the above-described polymer particles.

### [Star-shaped polymer compound (star type polymer compound)]

It is preferable that the binder polymer contains a polymer compound which has a polymer chain bonded to a nucleus through a sulfide bond by means of using a polyfunctional, in a range of tri- to deca-functional, thiol as the nucleus and in which the polymer chain has a polymerizable group (hereinafter, also referred to as a "star-shaped polymer compound" or a "star type polymer compound").

Moreover, as the polyfunctional thiol, a tetra- to deca-functional thiol is preferable.

In the star type polymer compound, the polyfunctional, in a range of tri- to deca-functional, thiol used as a nucleus can be suitably used as long as the compound has three to ten thiol groups in one molecule. Examples of such polyfunctional thiol compounds include compounds A, B, C, D, E, and F described in paragraphs 0021 to 0040 of JP2012-148555A. Among these polyfunctional thiols, from the viewpoints of printing durability and developability, the compounds A to E are preferable, the compounds A, B, D, and E are more preferable, the compounds A, B, and D are still more preferable, and the compound B is particularly preferable.

The weight-average molecular weight (Mw) of the star type polymer compound used in the present embodiment is preferably in a range of 5,000 to 500,000, more preferably in a range of 10,000 to 250,000, and particularly preferably in a range of 20,000 to 150,000. When the weight-average molecular weight thereof is in the above-described range, the developability and printing durability are improved.

The star type polymer compound used in the present embodiment may be used alone or in combination of two or more kinds thereof. Further, other binder polymers described below may be used in combination with the star type polymer compound.

The content of the star type polymer compound used in the present embodiment in the image recording layer is preferably in a range of 5% by mass to 95% by mass, more preferably in a range of 10% by mass to 90% by mass, and particularly preferably in a range of 15% by mass to 85% by mass with respect to the total solid content of the image recording layer.

From the viewpoint that the on-press developability is improved, star type polymer compounds described in JP2012-148555A are particularly preferable.

### [Other binder polymers]

Preferred examples of other binder polymers of the present embodiment include polymers having a crosslinkable functional group in the main or side chain, preferably in the side chain, for improving coated-film strength of an image portion as described in JP2008-195018A. Crosslinking occurs between polymer molecules by a crosslinkable group so that curing is promoted.

Preferred examples of the crosslinkable functional group include an ethylenically unsaturated group such as a (meth)acrylic group, a vinyl group, an allyl group, or a styryl group and an epoxy group, and these groups can be introduced into a polymer by a polymer reaction or copolymerization. For example, a reaction between an acrylic polymer having a carboxyl group in the side chain thereof or polyurethane and glycidyl methacrylate or a reaction between a polymer having an epoxy group and ethylenically unsaturated group-containing carboxylic acid such as methacrylic acid can be used.

The content of the crosslinkable group in the binder polymer is preferably in a range of 0.1 to 10.0 mmol, more preferably in a range of 1.0 to 7.0 mmol, and most preferably in a range of 2.0 to 5.5 mmol with respect to 1 g of the binder polymer.

Moreover, it is preferable that the binder polymer used in the present embodiment further includes a hydrophilic group. The hydrophilic group contributes to providing on-press developability for the image recording layer. Particularly, in the coexistence of a crosslinkable group and a hydrophilic group, both of printing durability and developability can be achieved.

Examples of the hydrophilic group include a hydroxyl group, a carboxyl group, an alkylene oxide structure, an amino group, an ammonium group, an amido group, a sulfo group, and a phosphoric acid group. Among these, an alkylene oxide structure having 1 to 9 alkylene oxide units having 2 or 3 carbon atoms is preferable. A monomer having a hydrophilic group may be copolymerized in order to provide a hydrophilic group for a binder polymer.

In addition, in order to control the impressing property, a lipophilic group such as an alkyl group, an aryl group, an aralkyl group, or an alkenyl group can be introduced into the binder polymer used in the present embodiment. Specifically, a lipophilic group-containing monomer such as methacrylic acid alkyl ester may be copolymerized.

The weight-average molecular weight (Mw) of the binder polymer in the present embodiment is preferably 2,000 or greater, more preferably 5,000 or greater, and still more preferably in a range of 10,000 to 300,000.

In the present embodiment, a hydrophilic polymer such as polyacrylic acid, polyvinyl alcohol, or a cellulose derivative (for example, carboxymethyl cellulose, carboxyethyl cellulose, methyl cellulose, hydroxypropyl cellulose, or methyl propyl cellulose) described in JP2008-195018A or a hydrophobic polymer such as polymethyl methacrylate can be used for the image recording layer, as necessary.

Further, a lipophilic binder polymer and a hydrophilic binder polymer may be used in combination.

The total content of the binder polymer is preferably in a range of 5% to 90% by mass, more preferably in a range of 5% to 80% by mass, and still more preferably in a range of 10% to 70% by mass with respect to the total solid content of the image recording layer.

Hereinafter, a polymerization initiator, a polymerizable compound, a colorant, a printing-out agent, and other components which are optional components of the image recording layer will be sequentially described.

### {Polymerization initiator}

It is preferable that the image recording layer contains a polymerization initiator. The polymerization initiator is not particularly limited and a known polymerization initiator can be used, but a radical polymerization initiator is preferable.

The radical polymerization initiator indicates a compound that generates a radical using light, heat, or energy of light and heat and starts and promotes polymerization of a radical polymerizable compound.

Examples of the radical polymerization initiator used for the image recording layer of the present invention include (a) an organic halide, (b) a carbonyl compound, (c) an azo compound, (d) an organic peroxide, (e) a metallocene compound, (f) an azido compound, (g) a hexaaryl biimidazole compound, (h) a borate compound, (i) a disulfone compound, (j) an oxime ester compound, and (k) an onium salt compound.

As the radical polymerization initiator, (k) an onium salt compound is preferably used, and a combination of (h) a barate compound and (k) an onium salt compound is more preferable.

The proportion of the radical polymerization initiator to be added is preferably in a range of 0.1% to 50% by mass, more preferably in a range of 0.5% to 30% by mass, and particularly preferably in a range of 0.8% to 20% by mass with respect to the total solid content constituting the image recording layer. When the proportion thereof is in the above-described range, excellent sensitivity and stain resistance of a non-image portion at the time of printing can be obtained.

### {Polymerizable compound}

It is preferable that the image recording layer contains a polymerizable compound. A radical polymerizable compound is preferable as the polymerizable compound and is also an addition polymerizable compound having at least one ethylenically unsaturated group. The polymerizable compound is selected from compounds having at least one and preferably two or more terminal ethylenically unsaturated groups. These have chemical forms such as a monomer, a dimer, a trimer, an oligomer, and a mixture of these.

Moreover, the polymerizable compound of the present invention does not contain the above-described polymer particles.

Examples of the monomer include unsaturated carboxylic acid (such as acrylic acid, methacrylic acid, itaconic acid, crotonic acid, isocrotonic acid, or maleic acid), and esters and amides thereof. Among these, esters of unsaturated carboxylic acid and a polyhydric alcohol compound and amides of unsaturated carboxylic acid and a polyhydric amine compound are preferably used. Further, addition reaction products with unsaturated carboxylic acid ester having a nucleophilic substituent such as a hydroxyl group, an amino group, or a mercapto group or amides and monofunctional or polyfunctional isocyanates or epoxies; and dehydration condensation reaction products with monofunctional or polyfunctional carboxylic acid are suitably used. Moreover, addition reaction products with unsaturated carboxylic acid ester having an electrophilic substituent such as an isocyanate group or an epoxy group or amides and monofunctional or polyfunctional alcohols, amines, or thiols; and substitution reaction products with unsaturated carboxylic acid ester having a leaving substituent such as a halogen group or a tosyloxy group or amides and monofunctional or polyfunctional alcohols, amines, or thiols are also suitably used. Further, as another example, compound groups replaced by unsaturated phosphonic acid, styrene, vinyl ether, and the like can be used in place of the above-described unsaturated carboxylic acid. These are described in references of JP2006-508380A, JP2002-287344A, JP2008-256850A, JP2001-342222A, JP1997-179296A (JP-H09-179296A), JP1997-179297A (JP-H09-179297A), JP1997-179298A (JP-H09-179298A), JP2004-294935A, JP2006-243493A, JP2002-275129A, JP2003-64130A, JP2003-280187A, and JP1998-333321A (JP-H10-333321A).

Specific examples of monomers of esters of a polyhydric alcohol compound and unsaturated carboxylic acid include acrylic acid ester such as ethylene glycol diacrylate, 1,3-butanediol diacrylate, tetramethylene glycol diacrylate, propylene glycol diacrylate, trimethylol propane triacrylate, hexanediol diacrylate, tetraethylene glycol diacrylate, pentaerythritol tetraacrylate, sorbitol triacrylate, isocyanuric acid ethylene oxide (EO)-modified triacrylate, or a polyester acrylate oligomer. Examples of the methacrylic acid ester include tetramethylene glycol dimethacrylate, neopentyl glycol dimethacrylate, trimethylol propane trimethacrylate, ethylene glycol dimethacrylate, pentaerythritol trimethacrylate, bis[p-(3-methacryloxy-2-hydroxypropoxy)phenyl]dimethyl methane, and bis-[p-(methacryloxyethoxy)phenyl]dimethylmethane. Specific examples of monomers of amides of a polyvalent amine compound and unsaturated carboxylic acid include methylene bis-acrylamide, methylene bis-methacrylamide, 1,6-hexamethylene bis-acrylamide, 1,6-hexamethylene bis-methacrylamide, diethylene triamine trisacrylamide, xylylene bisacrylamide, and xylylene bismethacrylamide.

Moreover, a urethane-based addition polymerizable compound produced using an addition reaction of isocyanate and a hydroxyl group is preferable, and specific examples thereof include a vinyl urethane compound which is formed by adding a vinyl monomer containing a hydroxyl group represented by the following Formula (A) to a polyisocyanate compound that has two or more isocyanate groups in one molecule described in JP1973-41708B (JP-S48-41708B) and contains two or more polymerizable vinyl groups in one molecule.

CH₂=C(R⁴)COOCH₂CH(R⁵)OH (A)

(In this case, R⁴ and R⁵ represent H or CH₃.)

In addition, urethane acrylates described in JP1976-37193A (JP-S51-37193A), JP1990-32293B (JP-H02-32293B), JP1990-16765B (JP-H02-16765B), JP2003-344997A, and JP2006-65210A; urethane compounds having an ethylene oxide-based skeleton described in JP1983-49860B (JP-S58-49860B), JP1981-17654B (JP-S56-17654B), JP1987-39417B (JP-S62-39417B), JP1987-39418B (JP-S62-39418B), JP2000-250211A, and JP2007-94138A; and urethane compounds having a hydrophilic group described in US7153632B, JP1996-505958A (JP-H08-505958A), JP2007-293221A, and JP2007-293223A are also preferable.

Among the examples described above, from the viewpoint that the balance between hydrophilicity associated with on-press developability and polymerization ability associated with printing durability is excellent, isocyanuric acid ethylene oxide-modified acrylates such as tris(acryloyloxyethyl) isocyanurate and bis(acryloyloxyethyl)hydroxyethyl isocyanurate are particularly preferable.

The details of the structures of these polymerizable compounds, whether to be used alone or in combination, and the usage method such as the addition amount can be arbitrarily set according to the final performance design of a planographic printing plate precursor. The content of the above-described polymerizable compound to be used is preferably in a range of 5% to 75% by mass, more preferably in a range of 25% to 70% by mass, and particularly preferably in a range of 30% to 60% by mass with respect to the total solid content of a photosensitive layer.

The weight-average molecular weight (Mw) of the polymerizable compound of the present embodiment is preferably 100 or greater and less than 2,000 and more preferably in a range of 200 to 1,000.

### {Colorant}

It is preferable that the image recording layer does not substantially contain a colorant. The expression "does not substantially contain" means that the image recording layer does not contain a colorant at all or the content of the colorant is less than 0.1% by mass with respect to the total mass of the solid content of the image recording layer, and it is preferable that the image recording layer does not contain a colorant at all.

In a case where the image recording layer contains a colorant, Oil Yellow #101, Oil Yellow #103, Oil Pink #312, Oil Green BG, Oil Blue BOS, Oil Blue #603, Oil Black BY, Oil Black BS, Oil Black T-505 (all manufactured by ORIENT CHEMICAL INDUSTRIES CO., LTD.), Victoria Pure Blue, Crystal Violet (CI42555), Methyl Violet (CI42535), Ethyl Violet, Rhodamine B (CI145170B), Malachite Green (CI42000), Methylene Blue (CI52015), and dyes described in JP1987-293247A (JP-S62-293247A) can be used. Further, a phthalocyanine-based pigment, an azo-based pigment, and pigments such as carbon black and titanium oxide can be suitably used.

### {Printing-out agent}

Since the image recording layer has printing-out properties resulting from the structural change of the above-described infrared absorbent, a reference mark can be detected with high precision even in a case where the image recording layer does not substantially contain a printing-out agent. The expression "does not substantially contain" means that the image recording layer does not contain a printing-out agent at all or the content of the printing-out agent is less than 0.1% by mass with respect to the total mass of the solid content of the image recording layer, and it is preferable that the image recording layer does not contain a printing-out agent at all.

In a case where the image recording layer contains a printing-out agent, compounds described in paragraphs [0122] and [0123] of JP2008-284817A are effectively used.

### {Other components}

Other components such as a surfactant, a low-molecular weight hydrophilic compound, a sensitizing agent, a polymerization inhibitor, a higher fatty acid derivative, a plasticizer, inorganic fine particles, an inorganic layered compound, a co-sensitizer, or a chain transfer agent can be added to the image recording layer used in the present embodiment. Further, it is preferable that the image recording layer contains organic fine particles. Examples of the organic fine particles include fine particles of the binder polymers of the present invention. The volume average particle diameter of these organic fine particles is preferably in a range of 0.1 to 100 µm.

### <Second embodiment>

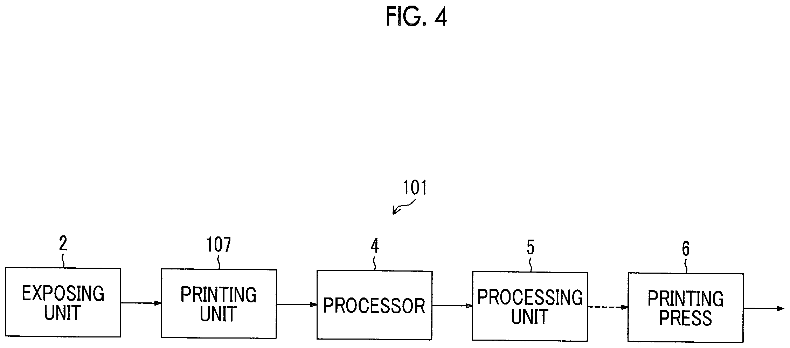

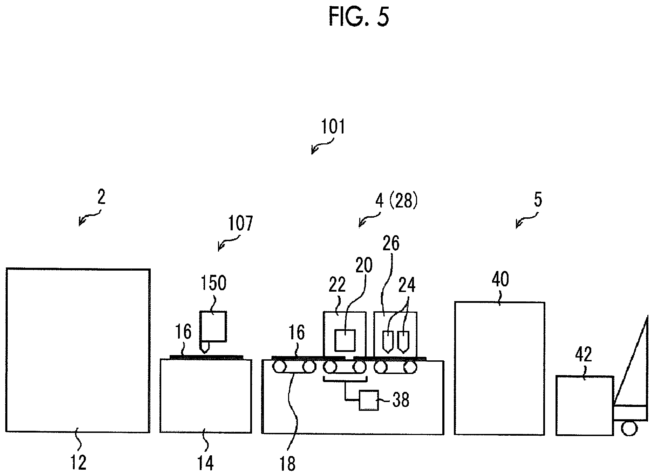

Fig. 4 is a flowchart showing a plate-making process of a plate-making system of a planographic printing plate according to a second embodiment and Fig. 5 is a view schematically illustrating the entire configuration of a plate-making system 101 of a planographic printing plate.

The plate-making system of a planographic printing plate according to the second embodiment is a plate-making system in a case of being carried out by an on-press development method. In the plate-making system 101 of a planographic printing plate according to the second embodiment, plate-making of the planographic printing plate is performed in order of the exposing unit 2, a printing unit 107, the processor 4, and the processing unit 5 without the developing unit 3 of the first embodiment.

The on-press development method is a printing method of supplying oily ink and aqueous components after a planographic printing plate is exposed without performing any developing process on the planographic printing plate precursor after exposure, and an unexposed portion in the planographic printing plate during the printing is removed. An image portion is exposed by the plate setter 12 or the like in the exposing unit 2 similar to the first embodiment, plate-making of a planographic printing plate is performed in order of the processor 4 and the processing unit 5, and the planographic printing plate is mounted on the printing press without performing a developing process on the planographic printing plate. Thereafter, when the oily ink and aqueous components are supplied and the printing is performed using the printing press, an on-press developing process in the initial stage during the printing, that is, the image recording layer in the unexposed region is removed and then the surface of a hydrophilic support is exposed so that a non-image portion is formed. As the oily ink and aqueous components, typical printing ink for planographic printing and dampening water may be used.

Moreover, as the exposing unit 2 of the plate-making system of a planographic printing plate which is performed using the on-press development method according to the second embodiment, it is preferable to use the following light sources other than the light source of the exposing unit of the plate-making system of a planographic printing plate according to the first embodiment.

A laser is preferable as the light source used for the exposing unit 2 of the planographic printing plate according to the second embodiment. The laser is not particularly limited, but a solid-state laser or a semiconductor laser applies infrared rays having a wavelength of 760 to 1,200 nm is suitably used.

In regard to the infrared laser, the output is preferably 100 mW or greater, the exposure time per pixel is preferably 20 microseconds or shorter, and the irradiation energy quantity is preferably in a range of 10 to 300 mJ/cm². In order to shorten the exposure time, it is preferable to use a multi-beam laser device for the laser.

In the plate-making system of a planographic printing plate according to the first embodiment, the plate-making is performed by developing a reference mark which becomes the reference of processing positions of the positioning perforation and the locking piece in the processing unit 5 after imagewise exposure. However, in the plate-making system of a planographic printing plate according to the second embodiment, the plate-making is performed by exposing the planographic printing plate precursor using the exposing unit 2.

As described above, according to the on-press development method, an image is unlikely to be visually confirmed because development is performed in the initial stage of printing and thus plate information is printed using the printing unit 107.

### <<Printing unit>>

The plate information is printed on the surface of the imagewise exposed planographic printing plate precursor using aqueous ink. Here, the plate information indicates information for mounting a plate cylinder on a proper position and examples thereof include issue dates, brand names, plate-making systems, the number of planes, colors, folding machine names, and follow-up information. As a method of printing the plate information, the plate information can be printed by an ink-jet coating device 150 using aqueous ink. Specifically, methods described in JP1998-52906A (JP-H10-52906A) and JP1998-166552A (JP-H10-166552A) can be applied thereto. In Fig. 5, the printing unit 107 is provided between the exposing unit 2 and the processor 4, but the position of the printing unit 107 is not particularly limited. For example, the printing unit 107 can be provided between the processor 4 and the processing unit 5.

Hereinafter, aqueous ink used for printing the plate information in the present embodiment will be described.

### [Aqueous ink]

In the present embodiment, the aqueous ink used for printing the plate information is a liquid obtained by dissolving a water-soluble dye in an aqueous medium.

### {Water-soluble dye}

Examples of the water-soluble dye include anionic dyes and cationic dyes with excellent solubility in water. The content of the water-soluble dye in the aqueous ink is preferably in a range of 0.1% to 10% by mass.

Examples of the water-soluble dye include an azo dye, a methine dye, an azomethine dye, a xanthene dye, a quinone dye, a phthalocyanine dye, a triphenylmethane dye, and a diphenylmethane dye.

From the viewpoint that the printed plate information becomes clearer, it is preferable that the color of the water-soluble dye is red-based or black-based by considering that the image portion of the on-press development type planographic printing plate precursor after exposure is blue-based.

An anionic dye is preferable as the water-soluble dye. It is preferable that the anionic dye includes -SO₃X (X represents Li, Na, or K) or -COOX (X represents Li, Na, or K) as a hydrophilic group.

### {Aqueous medium}

An aqueous medium is formed of water and an aqueous solvent. As water, ion exchange water or distilled water is preferably used. The aqueous solvent is suitably used to adjust drying of aqueous ink on the on-press development type planographic printing plate precursor and the content of the aqueous solvent is preferably in a range of 0.1% to 50% by mass with respect to the total mass of the aqueous ink. As the aqueous solvent, one or more selected from methanol, ethanol, isopropyl alcohol, t-butanol, glycerin, propylene glycol, ethylene glycol, polyethylene glycol, and the like are used.

### {Water-soluble fixing agent}

It is preferable that the aqueous ink contains a water-soluble fixing agent. Since dots are properly formed on the on-press development type planographic printing plate precursor and drying properties and appropriate fixing properties of the water-soluble ink, for example, fixing properties in which the ink is not easily removed even by the contact during the operation are provided by the water-soluble fixing agent, the content of the water-soluble fixing agent is in a range of 0.1% to 20% by mass and preferably in a range of 0.2% to 10% by mass with respect to the total mass of the water-soluble ink. As the water-soluble fixing agent, one or more selected from water-soluble polymers and saccharides are used.

### {Other components}

An antibacterial agent for preventing generation of fungi, a precipitation inhibitor for suppressing generation of insoluble matter over time, a pH adjusting agent for obtaining ink stability, an anti-foaming agent for preventing generation of bubbles during the production of ink, and a surfactant for improving solubility of a water-soluble dye may be further added to the aqueous ink.

### [Third embodiment]

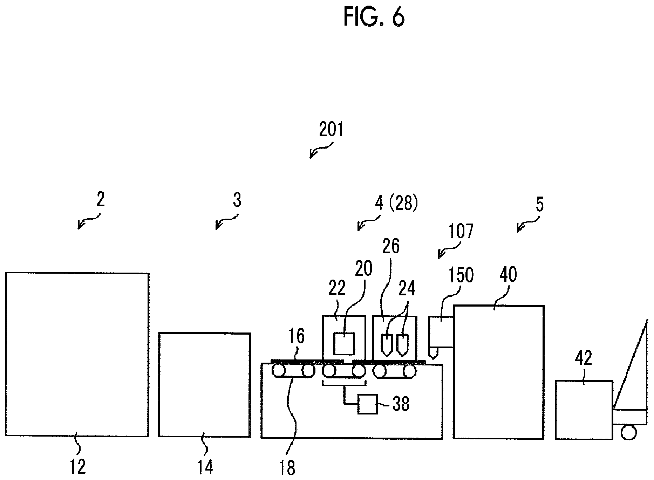

Fig. 6 is a view schematically illustrating the entire configuration of a plate-making system 201 of a planographic printing plate according to a third embodiment. The plate-making system of a planographic printing plate of the third embodiment is different from the plate-making system of a planographic printing plate of the first embodiment in terms that the printing unit 107 is provided for the plate-making system of a planographic printing plate of the first embodiment. Since wet development is performed by the developing unit 3 in the planographic printing plate system of the first embodiment, the planographic printing plate can be mounted on the plate cylinder of a designated printing press by verifying the image of the planographic printing plate and erroneous mounting can be prevented by printing plate information. The position of the printing unit 107 is provided between the processor 4 and the processing unit 5 in Fig. 6, but the position thereof is not particularly limited. For example, the position of the printing unit 107 may be provided between the developing unit 3 and the processor 4. Further, each configuration can be made the same as those of the plate-making systems of planographic printing plates of the first embodiment and the second embodiment.

### Explanation of References

- 1, 101, 201:: plate-making system of planographic printing plate
- 2:: exposing unit
- 3:: developing unit
- 4:: processor
- 5:: processing unit
- 6:: printing press
- 12:: plate setter
- 14:: automatic processor
- 16:: planographic printing plate precursor
- 18:: conveyor
- 20:: coating means
- 22:: coating unit
- 24:: drying means
- 26:: drying unit
- 28:: planographic printing plate processing device
- 30:: conveyance surface
- 32:: positioning pin
- 34:: guide rail
- 36:: driving motor
- 38:: processing liquid recovery unit
- 40:: punch bender
- 42:: stocker
- 107:: printing unit
- 150:: ink-jet coating device

## Claims

1. A planographic printing plate processing device (28) comprising:
a conveyor (18) which conveys a planographic printing plate precursor (16) or a planographic printing plate along a conveyance path; and
a coating unit (22) which is provided in the conveyance path and includes coating means (20) for coating a region within 1 cm from an end portion of at least one side of the planographic printing plate precursor (16) or the planographic printing plate with a processing liquid that contains a hydrophilizing agent, and
wherein the coating unit (22) comprises moving means for moving the coating means (20) from a movement start position provided outside or inside of one side end portion of the planographic printing plate precursor (16) or the planographic printing plate to a stopping position provided outside or inside of the planographic printing plate precursor (16) or the planographic printing plate by passing the coating means (20) over the planographic printing plate precursor (16) or the planographic printing plate in a direction perpendicular to the conveyance path of the planographic printing plate precursor (16) or the planographic printing plate.

2. The planographic printing plate processing device (28) according to claim 1,
wherein the planographic printing plate precursor (16) or the planographic printing plate is of an on-press development type.

3. The planographic printing plate processing device (28) according to any one of claim 1 to 2,
wherein the planographic printing plate precursor (16) or the planographic printing plate has an image recording layer containing at least an infrared absorbent and polymer particles.

4. The planographic printing plate processing device (28) according to claim 3,
wherein the polymer particle is a thermoplastic resin polymer.

5. A plate-making system (1, 101, 201) of a planographic printing plate comprising:
an exposing unit (2) which imagewise exposes a planographic printing plate precursor (16);
a developing unit (3) which removes an unexposed portion of the planographic printing plate precursor (16) imagewise exposed by the exposing unit (2);
a processor (4) which includes the planographic printing plate processing device (28) according to any one of claims 1, 3 or 4; and
a processing unit (5) which processes at least one of a positioning perforation or a locking piece used for mounting the planographic printing plate precursor (16) processed by the exposing unit (2) and the developing unit (3) on a printing press.

6. The plate-making system (1, 101, 201) of a planographic printing plate according to claim 5,
wherein developing and gumming are carried out using one liquid in the development process in the developing unit (3).

7. The plate-making system (1, 101, 201) of a planographic printing plate according to claim 5 or 6,
wherein the processing unit (5) includes an illumination light source and an imaging apparatus, wherein a polarizing plate and a phase difference plate having a quarter wavelength are disposed between the illumination light source and the planographic printing plate precursor, and between the imaging apparatus and the planographic printing plate precursor.

8. A plate-making system (1, 101, 201) of a planographic printing plate comprising:
an exposing unit (2) which imagewise exposes a planographic printing plate precursor (16);
a processor (4) which includes the planographic printing plate processing device (28) according to any one of claims 1 to 4; and
a processing unit (5) which processes at least one of a positioning perforation or a locking piece used for mounting the planographic printing plate precursor (16) processed by the exposing unit (2) on a printing press.

9. The plate-making system (1, 101, 201)of a planographic printing plate according to claim 8, further comprising:
a printing unit (107) which prints plate information on the planographic printing plate precursor (16).

10. The plate-making system (1, 101, 201) of a planographic printing plate according to claim 8 or 9,
wherein the processing unit (5) includes an illumination light source and an imaging apparatus, wherein a polarizing plate and a phase difference plate having a quarter wavelength are disposed between the illumination light source and the planographic printing plate precursor, and between the imaging apparatus and the planographic printing plate precursor.

11. A method of processing a planographic printing plate comprising:
processing a planographic printing plate using the planographic printing plate processing device (28) according to any one of claims 1 to 4, or
processing a planographic printing plate by the plate-making system (1, 101, 201) of a planographic printing plate according to any one of claims 5 to 10.

## Patentansprüche

1. Flachdruckplatten-Verarbeitungsvorrichtung (28), enthaltend:
ein Förderband (18), das einen Flachdruckplattenvorläufer (16) oder eine Flachdruckplatte entlang einem Förderweg fördert, und
eine Beschichtungseinheit (22), die in dem Förderweg vorgesehen ist und Beschichtungsmittel (20) zum Beschichten eines Bereiches innerhalb von 1 cm von einem Endbereich von zumindest einer Seite des Flachdruckplattenvorläufers (16) oder der Flachdruckplatte mit einer Verarbeitungslösung enthält, die ein Hydrophilisierungsmittel enthält und
worin die Beschichtungseinheit (22) Bewegmittel zum Bewegen des Beschichtungsmittels (20) von einer Bewegungsstartposition, die außerhalb oder innerhalb von einem Seitenendbereich des Flachdruckplattenvorläufers (16) oder der Flachdruckplatte angeordnet ist, zu einer Stopp-Position enthält, die außerhalb oder innerhalb des Flachdruckplattenvorläufers (16) oder der Flachdruckplatte vorgesehen ist, indem das Beschichtungsmittel (20) über dem Flachdruckplattenvorläufer (16) oder der Flachdruckplatte in einer Richtung senkrecht zu dem Förderweg des Flachdruckplattenvorläufers (16) oder der Flachdruckplatte geleitet wird.

2. Flachdruckplatten-Verarbeitungsvorrichtung (28) gemäß Anspruch 1, worin der Flachdruckplattenvorläufer (16) oder die Flachdruckplatte von einem Auf-der-Presse-Entwicklungstyp ist.

3. Flachdruckplatten-Verarbeitungsvorrichtung (28) gemäß einem der Ansprüche 1 bis 2, worin der Flachdruckplattenvorläufer (16) oder die Flachdruckplatte eine Bildaufzeichnungsschicht enthält, die zumindest einen Infrarotabsorber und Polymerteilchen enthält.

4. Flachdruckplatten-Verarbeitungsvorrichtung (28) gemäß Anspruch 3, worin das Polymerteilchen ein thermoplastisches Harzpolymer ist.

5. Plattenerzeugungssystem (1, 101, 201) einer Flachdruckplatte, enthaltend:
eine Belichtungseinheit (2), die bildweise einen Flachdruckplattenvorläufer (16) belichtet,
eine Entwicklungseinheit (3), die einen nichtbelichteten Bereich des Flachdruckplattenvorläufers (16) entfernt, der bildweise durch die Belichtungseinheit (2) belichtet ist,
einen Prozessor (4), der die Flachdruckplatten-Verarbeitungsvorrichtung (28) nach einem der Ansprüche 1, 3 oder 4 enthält, und
eine Verarbeitungseinheit (5), die zumindest eine von einer Positionierungsperforation oder einem Verriegelungsstück verarbeitet, die/der zum Befestigen des Flachdruckplattenvorläufers (16), der durch die Belichtungseinheit (2) verarbeitet ist, und der Entwicklungseinheit (3) auf einer Druckpresse verwendet wird.

6. Plattenerzeugungssystem (1, 101, 201) einer Flachdruckplatte gemäß Anspruch 5, worin die Entwicklung und Gummierung durchgeführt werden unter Verwendung von einer Flüssigkeit in dem Entwicklungsverfahren in der Entwicklungseinheit (3).

7. Plattenerzeugungssystem (1, 101, 201) einer Flachdruckplatte gemäß Anspruch 5 oder 6, worin die Verarbeitungseinheit (5) eine Beleuchtungslichtquelle und eine Bildgebungsanlage enthält, worin eine Polarisierungsplatte und eine Phasendifferenzplatte mit einer Viertel-Wellenlänge zwischen der Beleuchtungslichtquelle und dem Flachdruckplattenvorläufer und zwischen der Bildgebungsanlage und dem Flachdruckplattenvorläufer angeordnet sind.

8. Plattenerzeugungssystem (1, 101, 201) einer Flachdruckplatte, enthaltend:
eine Belichtungseinheit (2),die bildweise einen Flachdruckplattenvorläufer (16) belichtet,
einen Prozessor (4), der die Flachdruckplatten-Verarbeitungsvorrichtung (28) gemäß einem der Ansprüche 1 bis 4 enthält, und
eine Verarbeitungseinheit (5), die zumindest eine von einer Positionierungsperforation oder einem Verriegelungsstück, die zum Befestigen des Flachdruckplattenvorläufers (16), der durch die Belichtungseinheit (2) verarbeitet ist, auf einer Druckpresse verwendet wird, verarbeitet.

9. Plattenerzeugungssystem (1, 101, 201) einer Flachdruckplatte gemäß Anspruch 8, weiterhin enthaltend eine Druckeinheit (107), die Platteninformation auf den Flachdruckplattenvorläufer (16) druckt.

10. Plattenerzeugungssystem (1, 101, 201) einer Flachdruckplatte gemäß Anspruch 8 oder 9, worin die Verarbeitungseinheit (5) eine Beleuchtungslichtquelle und eine Bildgebungsanlage enthält, worin eine polarisierende Platte und eine Phasendifferenzplatte mit einer Viertel-Wellenlänge zwischen der Beleuchtungslichtquelle und dem Flachdruckplattenvorläufer und zwischen der Bildgebungsanlage und dem Flachdruckplattenvorläufer angeordnet sind.

11. Verfahren zum Verarbeiten einer Flachdruckplatte, enthaltend:
Verarbeiten einer Flachdruckplatte unter Verwendung der Flachdruckplatten-Verarbeitungsvorrichtung (28) gemäß einem der Ansprüche 1 bis 4 oder
Verarbeiten einer Flachdruckplatte durch das Plattenerzeugungssystem (1, 101, 201) einer Flachdruckplatte gemäß einem der Ansprüche 5 bis 10.

## Revendications

1. Dispositif de traitement de plaques d'impression lithographique (28) comprenant :
un convoyeur (18) qui transporte une plaque originale de plaque d'impression lithographique (16) ou une plaque d'impression lithographique le long d'un chemin de transport ; et
une unité de revêtement (22) qui est prévue dans le chemin de transport et qui inclut un moyen de revêtement (20) pour enduire une zone à moins de 1 cm d'une partie extrémité sur au moins un côté de la plaque originale de plaque d'impression lithographique (16) ou de la plaque d'impression lithographique avec un fluide de traitement qui contient un agent d'hydrophilisation, et
dans lequel l'unité de revêtement (22) comprend un moyen de déplacement pour déplacer le moyen de revêtement (20) entre une position de départ de déplacement prévue à l'extérieur ou l'intérieur d'une partie extrémité latérale de la plaque originale de plaque d'impression lithographique (16) ou de la plaque d'impression lithographique et une position d'arrêt prévue à l'extérieur ou à l'intérieur de la plaque originale de plaque d'impression lithographique (16) ou de la plaque d'impression lithographique en passant le moyen de revêtement (20) sur la plaque originale de plaque d'impression lithographique (16) ou la plaque d'impression lithographique dans une direction perpendiculaire au chemin de transport de la plaque originale de plaque d'impression lithographique (16) ou de la plaque d'impression lithographique.

2. Dispositif de traitement de plaques d'impression lithographique (28) selon la revendication 1,
dans lequel la plaque originale de plaque d'impression lithographique (16) ou la plaque d'impression lithographique est de type développement sur presse.

3. Dispositif de traitement de plaques d'impression lithographique (28) selon l'une quelconque de la revendication 1 et 2,
dans lequel la plaque originale de la plaque d'impression lithographique (16) ou la plaque d'impression lithographique présente une couche d'enregistrement d'image contenant au moins un absorbant dans l'infrarouge et des particules de polymère.

4. Dispositif de traitement de plaque d'impression lithographique (28) selon la revendication 3,
dans lequel la particule de polymère est un polymère de résine thermoplastique.

5. Système de fabrication de plaques (1, 101, 201) d'une plaque d'impression lithographique comprenant :
une unité d'exposition (2) qui expose en mode image une plaque originale de plaque d'impression lithographique (16) ;
une unité de développement (3) qui élimine une partie non exposée de la plaque originale de plaque d'impression lithographique (16) exposée en mode image par l'unité d'exposition (2) ;
un processeur (4) qui inclut le dispositif de traitement de plaques d'impression lithographique (28) selon l'une quelconque des revendications 1, 3 ou 4 ; et
une unité de traitement (5) qui traite au moins une parmi une perforation de positionnement ou une pièce de verrouillage utilisée pour monter l'image originale de plaque d'impression lithographique (16) traitée par l'unité d'exposition (2) et l'unité de développement (3) sur une presse d'impression.

6. Système de fabrication de plaques (1, 101, 201) d'une plaque d'impression lithographique selon la revendication 5,
dans lequel le développement et le gommage sont effectués en utilisant un liquide pendant le procédé de développement dans l'unité de développement (3).

7. Système de fabrication de plaques (1, 101, 201) d'une plaque d'impression lithographique selon la revendication 5 ou 6,
dans lequel l'unité de traitement (5) inclut une source de lumière d'éclairage et un appareil d'imagerie, dans lequel une plaque polarisante et une plaque à différence de phase présentant un quart de longueur d'onde sont disposées entre la source de lumière d'éclairage et l'image originale de plaque d'impression lithographique et entre l'appareil d'imagerie et la plaque originale de plaque d'impression lithographique.

8. Système de fabrication de plaques (1, 101, 201) d'une plaque d'impression lithographique comprenant :
une unité d'exposition (2) qui expose en mode image une plaque originale de plaque d'impression lithographique (16) ;
un processeur (4) qui inclut le dispositif de traitement de plaques d'impression lithographique (28) selon l'une quelconque des revendications 1 à 4 ; et
une unité de traitement (5) qui traite au moins une parmi une perforation de positionnement ou une pièce de verrouillage utilisée pour monter l'image originale de plaque d'impression lithographique (16) traitée par l'unité d'exposition (2) sur une presse d'impression.

9. Système de fabrication de plaques (1, 101, 201) d'une plaque d'impression lithographique selon la revendication 8, comprenant en outre :
une unité d'impression (107) qui imprime des informations de plaque sur l'image originale de plaque d'impression lithographique (16).

10. Système de fabrication de plaques (1, 101, 201) d'une plaque d'impression lithographique selon la revendication 8 ou 9,
dans lequel l'unité de traitement (5) inclut une source de lumière d'éclairage et un appareil d'imagerie, dans lequel une plaque polarisante et une plaque à différence de phase présentant un quart de longueur d'onde sont disposées entre la source de lumière d'éclairage et l'image originale de plaque d'impression lithographique, et entre l'appareil d'imagerie et l'image originale de plaque d'impression lithographique.

11. Procédé de traitement d'une plaque d'impression lithographique comprenant :
le traitement d'une plaque d'impression lithographique en utilisant le dispositif de traitement de plaques d'impression lithographique (28) selon l'une quelconque des revendications 1 à 4, ou
le traitement d'une plaque d'impression lithographique par le système de fabrication de plaques (1, 101, 201) d'une plaque d'impression lithographique selon l'une quelconque des revendications 5 à 10.
